# EUROPÄISCHE PATENTSCHRIFT

(11) **EP 1 097 457 B1**
(45) Veröffentlichungstag und Bekanntmachung des Hinweises auf die Patenterteilung: **09.04.2003**
(21) Anmeldenummer: 99944238.7
(22) Anmeldetag: 01.07.1999
(51) Int. Cl.: G11C 11/00

(54) **SPEICHERZELLENANORDNUNG, BEI DER EIN ELEKTRISCHER WIDERSTAND EINES SPEICHERELEMENTS EINE INFORMATION DARSTELLT UND DURCH EIN MAGNETFELD BEEINFLUSSBAR IST, UND VERFAHREN ZU DEREN HERSTELLUNG**
STORAGE CELL SYSTEM IN WHICH AN ELECTRIC RESISTANCE OF A STORAGE ELEMENT REPRESENTS AN INFORMATION UNIT AND CAN BE INFLUENCED BY A MAGNETIC FIELD, AND METHOD FOR PRODUCING SAME
ENSEMBLE CELLULE DE MEMOIRE DANS LEQUEL UNE RESISTANCE ELECTRIQUE D'UN ELEMENT DE MEMOIRE REPRESENTE UNE INFORMATION ET PEUT ETRE SOUMISE A L'INFLUENCE D'UN CHAMP MAGNETIQUE, ET SON PROCEDE DE REALISATION

(30) Priorität: 15.07.1998 DE 19831820
(43) Veröffentlichungstag der Anmeldung: 09.05.2001
(73) Patentinhaber: Infineon Technologies AG, 81669 München (DE)
(72) Erfinder: GOEBEL, Bernd, D-81735 München (DE); JACOBS, Hermann, D-83052 Bruckmühl (DE); SCHWARZL, Siegfried, D-85579 Neubiberg (DE); BERTAGNOLLI, Emmerich, A-1190 Wien (AT)
(74) Vertreter: Reinhard - Skuhra - Weise & Partner
(86) Internationale Anmeldenummer: DE9901958
(87) Internationale Veröffentlichungsnummer: WO00004555

(56) Entgegenhaltungen:
- EP-A- 0 613 148
- EP-A- 0 910 092
- PATENT ABSTRACTS OF JAPAN vol. 018, no. 349 (P-1763), 30. Juni 1994 (1994-06-30) & JP 06 084347 A (MITSUBISHI ELECTRIC CORP), 25. März 1994 (1994-03-25)

## Beschreibung

Die vorliegende Erfindung betrifft eine Speicherzellenanordnung mit magnetisch beeinflussbaren Speicherzellen und ein entsprechendes Herstellungsverfahren.

Aus der EP-A-0 613 148 ist eine Speicherzellenanordnung mit magnetisch beeinflußbaren Speicherelementen bekannt, welche jeweils über zwei Schalter mit Referenzpotentialen verbindbar sind und welche über gesonderte Schreibleitungen magnetisch beeinflußbar sind.

Aus Patents Abstracts of Japan, Vol. 018, Nr. 349 (P-1763), 30. Juni 1994 und der JP-A-06 084347 ist ein magnetischer Dünnschichtspeicher bekannt, bei dem Speicherzellen über einen Transistor zwischen senkrecht zueinander angeordneten Bitleitungen und Wortleitungen angeordnet sind.

Es gibt Elemente, deren elektrische Widerstände durch Magnetfelder beeinflußbar sind. Dazu gehören die sogenannten GMR-Elemente, die mindestens zwei ferromagnetische Schichten und eine dazwischen angeordnete nicht magnetische Schicht aufweisen und den sogenannten GMR- (giant magnetoresistiven) Effekt, das heißt sehr großen magnetoresistiven Effekt, zeigen. Unter dem GMR-Effekt wird die Tatsache verstanden, daß ein elektrischer Widerstand des GMR-Elements abhängig davon ist, ob die Magnetisierungen in den beiden ferromagnetischen Schichten parallel oder antiparallel zueinander ausgerichtet sind. Durch ein Magnetfeld lassen sich die Magnetisierungsrichtung einer oder beider Schichten und folglich der elektrische Widerstand des GMR-Elements ändern. Das GMR-Element weist bei zu den Ebenen der Schichten des Speicherelements senkrechtem Stromfluß ( CPP-Anordnung, current perpendicular to plane) einen anderen elektrischen Widerstand und Magnetowiderstandseffekt auf als bei zu den Ebenen der Schichten des Speicherelements parallelem Stromfluß ( CIP-Anordnung, current in plane) (vgl. F.W. Patten at al, Overview of the DARPA Non-Volatile Magnetic Memory Program, IEEE 1996, Seiten 1-2).

Ist die nicht magnetische Schicht leitend, so spricht man vom SV- (spin valve) Effekt. Ist die nicht magnetische Schicht isolierend, so spricht man vom ST- (spin tunneling) oder TMR-(tunneling magnetoresistance) Effekt (vgl. Patten et al a.a.O.).

Um die Magnetisierungsrichtungen der beiden ferromagnetischen Schichten mit einem Feld, das beide Schichten durchdringt, parallel bzw. antiparallel zueinander ausrichten zu können, sind die Schwellenfelder, d.h. die kleinsten Felder, die zur Änderung der Magnetisierungsrichtungen erforderlich sind, für die Schichten unterschiedlich. Die Höhe der Schwellenfelder ist durch die Wahl der Materialien, durch die Dicke der Schichten, durch die Größe und Richtung des Magnetfelds beim Abscheiden der Schichten und durch die Temperatur beim Abscheiden der Schichten beeinflußbar (vgl. J.S. Moodera et al, J. Appl. Phys. 79 (8) 1996 Seiten 4724 bis 4729). Eine andere Möglichkeit, das Schwellenfeld einer ferromagnetischen Schicht zu beeinflussen, besteht darin, angrenzend an die ferromagnetische Schicht eine antiferromagnetische Schicht anzuordnen, die die Magnetisierungsrichtung der ferromagnetischen Schicht quasi festhält und somit das Schwellenfeld der ferromagnetischen Schicht effektiv erhöht.

In D. D. Tang et al, IEDM 95, Seiten 997 bis 999 und in D. D. Tang et al, IEEE Trans. on Magnetics, Vol. 31, Nr. 6, 1995, Seiten 3206 bis 3208, ist vorgeschlagen worden, derartige GMR-Elemente als Speicherelemente in einer Speicherzellenanordnung zu verwenden. Die Magnetisierungsrichtung einer ersten ferromagnetischen Schicht eines Speicherelements wird durch eine benachbarte antiferromagnetische Schicht festgehalten. Die Magnetisierungsrichtung einer zweiten ferromagnetischen Schicht kann durch ein Magnetfeld, das größer als das Schwellenfeld der zweiten Schicht ist, verändert werden, ohne daß die Magnetisierungsrichtung der ersten Schicht verändert wird. Damit jedes Speicherelement separat programmiert werden kann, sind Schreibleitungen vorgesehen, die sich im Bereich der Speicherelemente kreuzen. Zum Programmieren der Speicherzelle wird das Magnetfeld erzeugt, indem Strom durch die zugehörigen zwei Schreibleitungen geschickt wird. Die Stromstärken sind so bemessen, daß erst die Überlagerung der Magnetfelder beider Schreibleitungen ausreicht, um die zur Veränderung der Magnetisierungsrichtung der zweiten ferromagnetischen Schicht erforderliche Mindeststärke zu überschreiten. Die Speicherelemente sind in Reihe geschaltet. Jeweils eine Reihe bildet eine Bitleitung. Die Schreibleitungen sind gegenüber den Bitleitungen und den Speicherelementen elektrisch isoliert. Zum Auslesen der Speicherzelle, d.h. zur Ermittlung der Magnetisierungsrichtung ihrer zweiten Schicht, wird zuerst ein Lesestrom durch die entsprechende Bitleitung geschickt und die daran abfallende Gesamtspannung gemessen. Dann wird durch die beiden Schreibleitungen ein Magnetfeld erzeugt, das größer als das Schwellenfeld der zweiten Schicht ist. Stimmt die Richtung des Magnetfeldes mit der ursprünglichen, d.h. der Information darstellenden Magnetisierungsrichtung der zweiten Schicht überein, so ändert sich die Gesamtspannung an der Bitleitung nicht. Andernfalls ändert das Magnetfeld die Magnetisierungsrichtung der zweiten Schicht mit der Folge, daß sich die Gesamtspannung ändert.

In S. Tehrani et al, IEDM 96, Seite 193 ff., ist vorgeschlagen worden, als Speicherelement ein GMR-Element zu verwenden, das unterschiedlich dicke ferromagnetische Schichten aufweist. Das Magnetfeld zum Einschreiben von Information wird so bemessen, daß es die Mindeststärke zur Änderung der Magnetisierungsrichtung der dickeren der beiden ferromagnetischen Schichten überschreitet. Zum Auslesen, d.h. zur Bestimmung der Magnetisierungsrichtung der dickeren Schicht, wird ein Magnetfeld eingestellt, das die dünnere, aber nicht die dikkere der beiden Schichten in eine ausgezeichnete Richtung magnetisiert, und die zugehörige Spannung an einer Bitleitung gemessen. Anschließend wird ein Magnetfeld eingestellt wird, das die dünnere Schicht in die entgegengesetzte Richtung magnetisiert und die zugehörige Spannung an der Bitleitung gemessen. Aus dem Vorzeichen der Differenz der Spannungen erhält man die Magnetisierungsrichtung der dickeren Schicht.

Die Magnetisierung in der dickeren der beiden ferromagnetischen Schichten bleibt vom Auslesen unbeeinflußt.

Der Auslesevorgang über den Vergleich zweier hintereinander gemessener Spannungen erfordert einen erhöhten Schaltungsaufwand und dauert lange.

In US 5 640 343 wird eine MRAM-Zellenanordnung beschrieben, bei der Speicherelemente in einem x-y-Raster angeordnet sind. Erste Leitungen verlaufen senkrecht zu zweiten Leitungen. Die Speicherelemente sind jeweils zwischen einer der ersten Leitungen und einer der zweiten Leitungen geschaltet. Für jedes Speicherelement existiert eine Vielzahl paralleler Strompfade, durch die eine zuverlässige Widerstandsbestimmung erschwert wird.

In US 5 173 873 wird eine MRAM-Zellenanordnung beschrieben, bei der ein Speicherelement eine magnetoresistive Schicht aufweist, die zwischen zwei ferromagnetischen Schichten angeordnet ist. Die Magnetisierungsrichtung einer der ferromagnetischen Schichten wird durch ein äußeres Magnetfeld geändert. Die andere der ferromagnetischen Schichten hat eine höhere Koerzitivkraft und ihre Magnetisierungsrichtung wird durch das Magnetfeld nicht verändert. Das Magnetfeld wird durch eine Leitung, die am Speicherelement vorbeiläuft, erzeugt. Das Vorzeichen des Stromflusses durch die Leitung bestimmt, ob die Information 0 oder 1 auf das Speicherelement geschrieben wird. Die Leitung ist über einen Transistor, der das Speicherelement unter anderen Speicherelementen beim Schreiben auswählt, mit einer Schreibleitung verbunden. Zum Schreiben und zum Auslesen der Information sind mehrere Transistoren und mehrere Leitungen pro Speicherelement vorgesehen, die das Speicherelement unter anderen Speicherelementen auswählen. Nachteilig an dieser MRAM-Zellenanordnung ist, daß aufgrund der vielen Transistoren und Leitungen pro Speicherzelle ihre Packungsdichte niedrig ist.

Der Erfindung liegt das Problem zugrunde, eine einfach herstellbar Speicherzellenanordnung anzugeben, bei der ein elektrischer Widerstand eines Speicherelements eine Information darstellt und durch ein Magnetfeld beeinflußbar ist. Ferner soll ein Herstellungsverfahren für eine solche Speicherzellenanordnung angegeben werden.

Dieses Problem wird gelöst durch eine Speicherzellenanordnung gemäß Anspruch 1 und ein Verfahren gemäß Anspruch 9. Ausgestaltungen der Erfindung gehen aus den übrigen Ansprüchen hervor.

Eine erfindungsgemäße Speicherzellenanordnung umfaßt Speicherzellen, die jeweils ein Speicherelement, dessen elektrischer Widerstand eine Information darstellt und von einem Magnetfeld beeinflußbar ist, und einen einzigen Transistor umfassen, wobei der Transistor beim Auslesen der Information die Auswahl der zugehörigen Speicherzelle unter den Speicherzellen gestattet.

Da die Transistoren die Auswahl einer Speicherzelle ermöglichen, ist die Messung zweier Spannungen zur Ermittlung des Widerstandes der zu lesenden Speicherzelle nicht erforderlich. Die anderen Speicherzellen haben keinen Einfluß auf die Spannung. Dies verringert sowohl die Lesedauer als auch den Schaltungsaufwand. Die Zuverlässigkeit der Messung des Widerstands wird auch durch große Zellenfelder nicht beeinträchtigt.

Die Speicherzellen sind mit Bitleitungen verbunden. Entlang einer der Bitleitungen zueinander benachbarte Speicherzellen sind nicht in Reihe zueinander geschaltet. Zum Auslesen einer der Speicherzellen wird der zugehörige Transistor über eine Gate-Leitung, die quer zur Bitleitung verläuft, angesteuert und der Widerstand des Speicherelements aus dem Strom oder der Spannung der zugehörigen Bitleitung bestimmt. Da die Speicherzellen nicht als Teil der Bitleitung in Reihe geschaltet sind, beeinflußt nur die zu lesende Speicherzelle den Strom oder die Spannung der zugehörigen Bitleitung. Die übrigen Speicherzellen haben keinen Einfluß auf den Strom oder die Spannung.

Im Stand der Technik sind die Speicherzellen oft in Reihe geschaltet. Der zu messende Strom fließt nicht nur durch die auszulesende Speicherzelle, weshalb er durch andere Speicherzellen verkleinert wird. Aufgrund der Verkleinerung des Stroms, muß schon für eine geringe Zahl von hintereinander geschalteten Speicherzellen ein Leseverstärker vorgesehen werden, was einen großen Flächenbedarf zur Folge hat.

Ein Vorteil der im Rahmen der Erfindung vorgeschlagenen Verschaltung ist, daß der Strom nicht durch andere Speicherzellen fließt und deshalb nicht unnötig verkleinert wird. Außerdem läßt sich eine besonders hohe Packungsdichte der Speicherzellenanordnung erzielen, da weniger Leseverstärker benötigt werden.

Für die erfindungsgemäße Schaltungsanordnung sind Schreibleitungen vorgesehen, die quer zu den Bitleitungen verlaufen und die in Bereichen der Speicherelemente die Bitleitungen kreuzen. Die Speicherelemente sind zwischen den sich kreuzenden Schreibleitungen und Bitleitungen angeordnet. Zum Programmieren einer Speicherzelle wird ein Strom durch die zugehörige Schreibleitung und ein Strom durch die zugehörige Bitleitung geschickt. Dabei erzeugen die Ströme ein Magnetfeld, das in der Speicherzelle stärker ist als in den in den übrigen Speicherzellen. Damit das Magnetfeld in der Speicherzelle möglichst groß ist, ist es vorteilhaft, wenn die Bitleitung und die Schreibleitung möglichst nah am Speicherelement angeordnet sind.

Durch die sich kreuzenden Schreibleitungen und Bitleitungen kann eine zu programmierende Speicherzelle unter den anderen Speicherzellen ausgewählt werden. Im Gegensatz zu US 5 173 873 benötigt die Speicherzelle keinen Transistor zur Auswahl beim Schreiben, so daß sich eine größere Packungsdichte realisieren läßt.

Zur Prozeßvereinfachung und zur Erhöhung der Packungsdichte ist es vorteilhaft, wenn Gateelektroden der Transistoren Teile der Gate-Leitungen sind.

Der Transistor kann z.B. planar ausgebildet sein. Dies bietet den Vorteil, daß die Standardtechnologie zur Herstellung des Transistors anwendbar ist. Zur Erhöhung der Packungsdichte ist es darüber hinaus vorteilhaft, wenn die Transistoren vor. entlang der Bitleitung benachbarten Speicherzellen paarweise ein gemeinsames Source/Drain-Gebiet aufweisen.

Zur Erhöhung der Packungsdichte der Speicherzellenanordnung kann der Transistor vertikal ausgebildet sein.

Die Speicherzellen können mit einem gemeinsamen Spannungsanschluß verbunden sein. Beim Auslesen der Speicherzelle fließt der Strom zwischen dem Spannungsanschluß und der Bitleitung durch die Speicherzelle.

Alternativ können die Speicherzellen mit den Schreibleitungen so verbunden sein, daß beim Auslesen der Strom zwischen der zugehörigen Schreibleitung und der zugehörigen Bitleitung durch die auszulesende Speicherzelle fließt.

Um die Anzahl an Leitungen zu verkleinern und folglich die Packungsdichte zu erhöhen, ist es vorteilhaft, wenn die Schreibleitung und die Gate-Leitung zusammenfallen. Dies ist insbesondere dann möglich, wenn die Speicherzellen mit dem gemeinsamen Spannungsanschluß verbunden sind. Da in der Standardtechnclogie die Gateelektroden gleich nach der Erzeugung von Gatedielektrika erzeugt werden, ist es für den Fall, daß die Gateelektroden Teile der Gate-Leitungen sind, vorteilhaft, wenn zunächst die Gate-Leitungen und in einem späteren Prozeßschritt angrenzend an die Gate-Leitungen die Schreibleitungen erzeugt werden. In diesem Fall können für die Schreibleitung und für die Gate-Leitung unterschiedliche Materialien verwendet werden. Alternativ werden die Schreibleitung und die Gate-Leitung in einem Schritt als gemeinsame Leitung erzeugt.

Um Hintergrundrauschen, das für benachbarte Bitleitungen ähnlich ist, herauszufiltern, ist es vorteilhaft, die Speicherzellenanordnung mit folded Bitleitungen zu versehen. Bei folded Bitleitungen wird beim Auslesen der Speicherzelle die Differenz zwischen Strömen oder Spannungen der entsprechenden Bitleitung und einer benachbarten Bitleitung gebildet. Damit der Strom bz. Die Spannung der benachbarten Bitleitung nur Hintergrundrauschen darstellt, ist es erforderlich, daß die zur Speicherzelle zugehörige Gate-Leitung mit keiner Speicherzelle elektrisch verbunden ist, die mit der benachbarten Bitleitung elektrisch verbunden ist.

Zur Prozeßvereinfachung ist es vorteilhaft, keine folded Bitleitungen vorzusehen. Man spricht dann von sogenannten open Bitleitungen.

Wird der Transistor als vertikaler Transistor ausgebildet, kann eine Halbleiterstruktur erzeugt werden, in der ein erstes Source/Drain-Gebiet des Transistors über einem Kanalgebiet angeordnet ist. Ein zweites Source/Drain-Gebiet des Transistors kann unterhalb des Kanalgebiets oder diagonal nach unten versetzt zum Kanalgebiet angeordnet sein. Die Gate-Leitung ist mindestens an einer ersten Flanke der Halbleiterstruktur angeordnet.

Zur Erhöhung der Packungsdichte ist es vorteilhaft, wenn eine zur Gate-Leitung benachbarte Gate-Leitung an einer zweiten, der ersten Flanke gegenüberliegenden Flanke angeordnet ist. In diesem Fall grenzt im Bereich des Kanalgebiets ein Element, das die Ausbildung eines Kanals verhindert, an die zweite Flanke an. Auf diese Weise wird verhindert, daß die benachbarte Gate-Leitung den Transistor steuert.

Alternativ kann die Gate-Leitung z.B. sowohl an der ersten Flanke als auch an der zweiten Flanke angeordnet sein.

Das Element, das die Ausbildung eines Kanals verhindert, kann zur Erhöhung der Packungsdichte z.B. ein Channel-Stop-Gebiet sein. Das Channel-Stop-Gebiet ist vom selben Leitfähigkeitstyp wie das Kanalgebiet dotiert, weist aber eine höhere Dotierstöffkonzentration auf. Das Channel-Stop-Gebiet kann z.B. durch schräge Implantation oder durch Ausdiffusion von Dotierstoff aus einem Material erzeugt werden.

Das Element, das die Ausbildung eines Kanals verhindert, kann zur Erhöhung der Packungsdichte z.B. auch in Form einer vorzugsweise spacerförmigen isolierenden Struktur erzeugt werden.

Zur Erzeugung der Halbleiterstruktur können Gräben in einem Substrat oder in über dem Substrat angeordneten Schichten erzeugt werden, wodurch die Halbleiterstruktur in Form eines Streifens entsteht. Die Gate-Leitungen werden in den Gräben erzeugt. Die Halbleiterstruktur ist Teil von Speicherzellen, die entlang der Gate-Leitung zueinander benachbart sind. Damit die Gate-Leitung zwischen ersten Source/Drain-Gebieten der Halbleiterstruktur keine Kanäle erzeugt, können zwischen benachbarten ersten Source/Drain-Gebieten weitere Elemente, die die Ausbildung von Kanälen verhindern, angeordnet sein.

Alternativ wird für jede Speicherzelle eine Halbleiterstruktur erzeugt, indem in dem Substrat oder in über dem Substrat angeordneten Schichten, eine gitterförmige Vertiefung in Form von ersten Gräben und quer zu den ersten Gräben verlaufenden zweiten Gräben erzeugt wird, wodurch die Halbleiterstruktur in Form eines Quaders entsteht. Die Gate-Leitungen werden in der gitterförmigen Vertiefung, z.B. in den und entlang der ersten Gräben, erzeugt. Zwischen entlang der Gate-Leitung benachbarten Halbleiterstrukturen können in der gitterförmigen Vertiefung, z.B. in den zweiten Gräben, isolierende Strukturen erzeugt werden, die die Ausbildung von Kanälen verhindern.

Ebenfalls möglich ist es, die Gate-Leitung in der gitterförmigen Vertiefung auch zwischen den entlang der Gate-Leitung benachbarten Halbleiterstrukturen anzuordnen. In diesem Fall umgibt die Gate-Leitung die Halbleiterstruktur ringförmig. Diese Anordnung ist zur Vergrößerung der Kanalweite und damit zur Erhöhung der Stromstärke durch den Transistor vorteilhaft. Damit quer zur Gate-Leitung benachbarte Halbleiterstrukturen von verschiedenen Gate-Leitungen angesteuert werden können, teilen sich zueinander benachbarte Gate-Leitungen einen der ersten Gräben. Zur Erhöhung der Packungsdichte ist es vorteilhaft, wenn in den ersten Gräben angeordnete Teile der Gate-Leitungen spacerförmig sind.

Ist die Gate-Leitung nur an der ersten Flanke der Halbleiterstruktur angeordnet und sind folded Bitleitungen vorgesehen, so ist es zur Erhöhung der Packungsdichte vorteilhaft, wenn zueinander benachbarte Gate-Leitungen zusammen in einem der Gräben angeordnet sind. In diesem Fall grenzen die Elemente, die die Ausbildung von Kanälen verhindern, alternierend an eine erste Flanke und an eine zweite Flanke der Gräben an, in denen die Gate-Leitungen angeordnet sind. Zur Erhöhung der Packungsdichte ist es besonders vorteilhaft, wenn die Gate-Leitungen spacerförmig sind. Sind keine folded Bitleitungen vorgesehen, ist es zur Prozeßvereinfachung vorteilhaft, wenn die Gate-Leitung den Graben ausfüllt.

Als Speicherelement ist jedes Element geeignet, dessen elektrischer Widerstand durch ein Magnetfeld beeinflußbar ist.

Auf bewegte Elektronen, die ein Magnetfeld durchlaufen, wirkt die sogenannte Lorentzkraft senkrecht zur Bewegungsrichtung. Als Speicherelement läßt sich eine Schicht aus einem Material verwenden, bei dem die Lorentzkraft bewirkt, daß die Elektronen an eine Seite der Schicht gedrängt werden. Im Vergleich zum elektrischen. Widerstand der Schicht ohne Magnetfeld bewirkt das Magnetfeld eine effektive Verkleinerung des zum Stromfluß senkrechten Querschnitts der Schicht und demzufolge eine Vergrößerung des elektrischen Widerstands.

Als Speicherelement kann eine Schicht aus einem Material vorgesehen sein, der den sogenannten anisotropen Magnetowiderstandseffekt zeigt. Dieser Effekt ist eine Eigenschaft des Materials und bewirkt, daß die Größe des elektrischen Widerstands davon abhängt, ob das Magnetfeld senkrecht oder parallel zum Stromfluß anliegt.

Es liegt im Rahmen der Erfindung, wenn das Speicherelement ein GMR-Element ist. Es können auch TMR-Elemente eingesetzt werden.

Beispielsweise umfaßt das Speicherelement eine erste magnetische Schicht, die ein erstes Schwellenfeld zur Änderung ihrer Magnetisierungsrichtung benötigt, und eine zweite magnetische Schicht, die ein zweites Schwellenfeld zur Änderung ihrer Magnetisierungsrichtung benötigt, wobei die zwei magnetischen Schichten durch eine nicht magnetische Schicht voneinander getrennt sind. Die nicht magnetische Schicht kann z.B. ein Dielektrikum oder leitend sein. Alternative Möglichkeiten zur Ausgestaltung des Speicherelements, wie z.B. die Anordnung einer antiferromagnetischen Schicht zum Festhalten der Magnetisierungsrichtung einer der magnetischen Schichten, finden sich z.B. im Stand der Technik, der im einleitenden Teil dieser Beschreibung dargestellt ist. Die magnetischen Schichten sind beispielsweise ferromagnetisch.

Der Stromfluß durch das Speicherelement kann senkrecht (CPP-Anordnung oder parallel (CIP-Anordnung) zu den Ebenen der Schichten des Speicherelements verlaufen.

Damit das zur Programmierung erzeugte Magnetfeld nicht das gesamte Speicherelement homogen durchdringen muß, ist es vorteilhaft, wenn die Abmessungen der magnetischen Schichten derart sind, daß jede Schicht jeweils nur eine magnetische Domäne umfaßt. Innerhalb einer Domäne ist die Magnetisierungsrichtung im wesentlichen homogen. Durchdringt das Magnetfeld den größten Teil der Schicht, so ändert sich die Magnetisierungsrichtung der gesamten Domäne und damit der gesamten Schicht. Ein weiterer Vorteil ist, daß der Widerstand eines solchen Speicherelements wohldefinierte Werte annimmt. Umfaßt die Schicht dagegen mehrere Domänen, so kann der Widerstand aufgrund unterschiedlicher Magnetisierungsrichtungen der Domänen variieren. Auch die Schaltgeschwindigkeit des Speicherelements, dessen magnetische Schichten jeweils nur eine Domäne umfassen, ist größer, da eine Änderung der Magnetisierungsrichtung durch Drehung der Magnetisierung erfolgt. Bei einem Speicherelement, dessen magnetische Schichten jeweils mehrere Domänen umfassen, erfolgt die Änderung der Magnetisierungsrichtung sowohl durch Drehung der Magnetisierung als auch durch Verschiebung von Domänenwänden.

Als Materialien für die magnetischen Schichten eignen sich z.B. Ni, Fe, Co, Cr, Mn, Gd, Dy und Legierungen daraus, wie NiFe, NiFeCo, CoFe, CoCrFe, sowie MuBi, BiFe, CoSm, CoPt, CoMnB, CoFeB. Als isolierende Materialien für die nicht magnetische Schicht eigenen sich z.B. Al₂O₃, MgO, NiO, HfO₂, TiO₂, NbC, SiO₂ und DLC (diamond-like carbon). Als leitende Materialien für die nicht magnetische Schicht eignen sich z.B. Cu oder Ag.

Um ein hinreichend großes Schwellenfeld zu erzielen, kann für die betreffende magnetische Schicht ein Material mit einer hohen Koerzitivkraft verwendet werden. Eine Abscheidung des Materials in einem Magnetfeld oder Tempern des abgeschiedenen Materials in einem Magnetfeld kann ebenfalls ein besonders großes Schwellenfeld bewirken.

Vorzugsrichtungen der Magnetisierungen können durch Abscheidung oder Tempern der magnetischen Schichten im Magnetfeld erzeugt werden. Diesen Methoden liegen physikalische Effekte, wie Kristallanisotropie und uniaxiale Anisotropie, zugrunde.

Das Speicherelement kann mehr als zwei übereinander angeordnete magnetische Schichten aufweisen, die durch nicht magnetische Schichten voneinander getrennt sind.

Das Speicherelement kann neben dem Transistor angeordnet sein. Zur Erhöhung der Packungsdichte ist es vorteilhaft, wenn das Speicherelement über oder unter dem Transistor angeordnet ist.

Ist das Speicherelement über dem Transistor angeordnet, kann auf dem ersten Source/Drain-Gebiet ein Kontakt angeordnet sein. Neben dem Kontakt kann die Schreibleitung angeordnet sein, auf der eine Isolation angeordnet ist. Oberhalb der Isolation und oberhalb und angrenzend an den Kontakt wird das Speicherelement erzeugt. Über dem Speicherelement kann die Bitleitung erzeugt werden.

Es ist vorteilhaft, wenn die Isolation auf der Schreibleitung möglichst dünn ist, damit der Einfluß der Schreibleitung auf das Speicherelement, d.h. das von der Schreibleitung erzeugte Magnetfeld am Ort des Speicherelements, möglichst groß ist. Zur Erzeugung der Isolation kann der Kontakt im Gegensatz zur Schreibleitung aus einem harten leitenden Material erzeugt werden. Nach Erzeugung des Kontakts und der Schreibleitung, deren obere Flächen beispielsweise zunächst auf gleicher Höhe liegen, wird die Schreibleitung durch chemisch mechanisches Polieren etwas abgetragen, bis der Kontakt aufgrund der Härte des Materials etwas hervorsteht. Die oberen Flächen der Schreibleitung und des Kontakts liegen nun auf unterschiedlichen Höhen. Zur Erzeugung der Isolation wird isolierendes Material abgeschieden und durch chemisch-mechanisches Polieren planarisiert, bis die obere Fläche des Kontakts freigelegt wird. Die Dicke der Isolation hängt von der Differenz zwischen den Höhen der oberen Flächen der Schreibleitung und des Kontakts ab, d.h. sie hängt davon ab, wie weit der Kontakt hervorragte.

Da der Kontakt an das Speicherelement angrenzt und die Schreibleitung möglichst nah am Speicherelement angeordnet sein sollte, ist es zur Erhöhung der Packungsdichte vorteilhaft, wenn der Kontakt und die Schreibieitung möglichst dicht beieinander angeordnet sind. Dazu kann nach Erzeugung des Transistors eine isolierende Schicht erzeugt werden, in der der Kontakt erzeugt wird. Mit Hilfe einer streifenförmigen Maske, die den Kontakt teilweise überlappt, wird die isolierende Schicht selektiv zum Kontakt geätzt. Anschließend wird leitendes Material abgeschieden und rückgeätzt oder planarisiert, wodurch die Schreibleitung erzeugt wird.

Um die Schreibleitung elektrisch vom Kontakt zu isolieren, kann vor Erzeugung der Schreibleitung eine Trennschicht mindestens an den freigelegten Flächen des Kontakts erzeugt werden. Alternativ wird zur Erzeugung des Kontakts zunächst ein Kontaktloch erzeugt, deren Seitenflächen mit der Trennschicht versehen werden und das anschließend mit leitendem Material gefüllt wird. Die Trennschicht wird bei der Erzeugung der Schreibleitung selektiv zur isolierenden Schicht geätzt. Dies gilt analog auch für die Bitleitung, falls die Bitleitung unter dem Speicherelement angeordnet ist.

Soll die Gate-Leitung mit der Schreibleitung zusammenfallen, wird bei der Erzeugung der Schreibleitung die isolierende Schicht durchtrennt, bis die Gate-Leitung freigelegt wird.

Der Kontakt kann das Speicherelement statt von unten auch von der Seite kontaktieren. Dies ist insbesondere vorteilhaft für den Fall, daß der Stromfluß durch das Speicherelement parallel zu der. Ebenen seiner Schichten verläuft. Verläuft der Stromfluß vertikal zu den Ebenen der Schichten des Speicherelements, so kann, falls der Kontakt nach dem Speicherelement erzeugt wird, zunächst ein Kontaktloch erzeugt werden, das an das Speicherelement angrenzt. Durch Abscheiden und Rückätzen wird an Seitenflächen des Kontaktlochs die Trennschicht erzeugt, die bis unterhalb der ersten magnecischen Schicht des Speicherelements reicht. Durch Abscheiden von leitendem Material wird das Kontaktloch gefüllt. Anschließend wird das leitende Material rückgeätzt, bis ein Kontakt erzeugt wird, dessen obere Fläche in der Höhe der ersten magnetischen Schicht liegt. Die zweite magnetische Schicht wird von der Bitleitung kontaktiert.

Die Speicherzellenanordnung kann insbesondere als MRAM-Speicherzellenanordnung verwendet werden.

Im folgenden wird eine mögliche Betriebsweise erläutert.

Zum Programmieren einer Speicherzelle wird Strom durch die zugehörige Schreibleitung und durch die zugehörige Bitieitung geschickt. Je nach Richtung der Ströme wird die Magnetisierungsrichtung der magnetisch weicheren der beiden magnetischen Schichten parallel oder antiparallel zur Magnetisierungsrichtung der magnetisch härteren der beiden magnetischen Schichten, deren Magnetisierungsrichtung nicht verändert wird, eingestellt.

Zum Auslesen wird der Transistor über die zugehörige Gate-Leitung angesteuert und es wird ein Strom durch die Speicherzelle geschickt, der an der Bitleitung ausgelesen wird. Der Strom durch die oder der Spannungsabfall an der Speicherzelle hängt vom elektrischen Widerstand des Speicherelements ab, der wiederum von der Magnetisierungsrichtung der weicheren der beiden magnetischen Schichten abhängt.

Im folgenden werden Ausführungsbeispiele der Erfindung, die in den Figuren dargestellt sind, näher erläutert.
- Figur 1a: zeigt einen Querschnitt durch ein erstes Substrat, nachdem eine erste Schicht, eine zweite Schicht, streifenförmige dotierte Gebiete und eine erste Maske erzeugt wurden.
- Figur 1b: zeigt einen zum Querschnitt aus Figur 1a senkrechten Querschnitt durch das erste Substrat, nach den Prozeßschritten aus Figur 1a.
- Figur 2: zeigt den Querschnitt aus Figur 1a, nachdem Gräben, Halbleiterstrukturen, erste Source/Drain-Gebiete, Kanalgebiete, zweite Source/Drain-Gebiete und Channel-Stop-Gebiete erzeugt wurden.
- Figur 3a: zeigt den Querschnitt aus Figur 2, nachdem ein Gatedielektrikum, Gate-Leitungen, eine erste isolierende Schicht, Trennschichten, Kontakte und Schreibleitungen erzeugt wurden.
- Figur 3b: zeigt den Querschnitt aus Figur 1b nach den Prozeßschritten aus Figur 3a.
- Figur 3c: zeigt eine Aufsicht auf das erste Substrat, in der die Gräben, Kontakte und eine zweite Maske dargestellt sind.
- Figur 4a: zeigt den Querschnitt aus Figur 3a, nachdem eine Isolation, eine erste magnetische Schicht, eine nicht magnetische Schicht, eine zweite magnetische Schicht, eine zweite isolierende Schicht, Bitleitungen und eine vierte Maske erzeugt wurden.
- Figur 4b: zeigt den Querschnitt aus Figur 3b nach den Prozeßschritten aus Figur 4a.
- Figur 4c: zeigt ein Schaltbild einer ersten MRAM-Zellenanordnung.
- Figur 5a: zeigt einen Querschnitt durch ein zweites Substrat, nachdem eine erste Schicht, eine zweite Schicht, eine dritte Schicht und eine erste Maske erzeugt wurden.
- Figur 5b: zeigt einen zum Querschnitt aus Figur 5a senkrechten Querschnitt durch das zweite Substrat nach den Prözeßschritten aus Figur 5a.
- Figur 6a: zeigt den Querschnitt aus Figur 5a, nachdem eine gitterförmige Vertiefung, Halbleiterstrukturen, ein Gatedielektrikum, erste Source/Drain-Gebiete, Kanalgebiete, zweite Source/Drain-Gebiete und Gate-Leitungen erzeugt wurden.
- Figur 6b: zeigt den Querschnitt aus Figur 5b nach den Prozeßschritten aus Figur 6a.
- Figur 7a: zeigt den Querschnitt aus Figur 6a nachdem eine erste isolierende Schicht, Trennschichten, Kontakte, Schreibleitungen und eine zweite isolierende Schicht erzeugt wurden.
- Figur 7b: zeigt den Querschnitt aus Figur 6b nach den Prozeßschritten aus Figur 7a.
- Figur 8a: zeigt den Querschnitt aus Figur 7a, nachdem eine Isolation, Speicherelemente, eine dritte isolierende Schicht und Bitleitungen erzeugt wurden.
- Figur 8b: zeigt den Querschnitt aus Figur 7b nach den Prozeßschritten aus Figur 8a.
- Figur 9: zeigt die Aufsicht auf ein drittes Substrat, nachdem eine isolierende Struktur erzeugt wurde.
- Figur 10: zeigt einen Querschnitt durch das dritte Substrat, nachdem die erste isolierende Struktur, erste Source/Drain-Gebiete, zweite Source/Drain-Gebiete, Kanalgebiete, Gate-Leitungen und Ätzstop-Strukturen erzeugt wurden.
- Figur 11a: zeigt den Querschnitt aus Figur 10, nachdem eine erste isolierende Schicht, Trennschichten, Kontakte und Schreib-Leitungen erzeugt wurden.
- Figur 11b: zeigt einen zum Querschnitt aus Figur 11a senkrechten Querschnitt durch das dritte Substrat nach den Prozeßschritten aus Figur 11a.
- Figur 12a: zeigt den Querschnitt aus Figur 11a, nachdem eine Isolation, Speicherelemente, eine zweite isolierende Schicht und Bitleitungen erzeugt wurden.
- Figur 12b: zeigt den Querschnitt aus Figur 11b nach den Prozeßschritten aus Figur 12a.
- Figur 13: zeigt einen Querschnitt durch ein viertes Substrat, nachdem eine erste Maske, Gräben, Hälbleiterstrukturen, erste Source/Drain-Gebiete, Kanalgebiete, zweite Source/Drain-Gebiete, Channel-Stop-Gebiete, ein Gatedielektrikum, Gate-Leitungen, eine erste isolierende Schicht, Schreibleitungen, eine Isolation, eine zweite Metallschicht, eine erste magnetische Schicht, ein Dielektrikum, eine zweite magnetische Schicht, eine dritte Metallschicht, eine zweite isolierende Schicht und eine vierte Metallschicht erzeugt wurden.
- Figur 14: zeigt den Querschnitt aus Figur 13 nachdem eine dritte isolierende Schicht, eine vierte isolierende Schicht, eine zweite Maske, Kontaktlöcher und Trennschichten erzeugt wurden.
- Figur 15: zeigt einen Querschnitt aus Figur 14 nachdem Kontakte erzeugt wurden.
- Figur 16a: zeigt einen Querschnitt aus Figur 15, nachdem eine fünfte isolierende Schicht und Bitleitungen erzeugt wurden.
- Figur 16b: zeigt einen zum Querschnitt aus Figur 16a senkrechten Querschnitt durch das vierte Substrat nach den Drozeßschritten aus Figur 16a.
- Figur 17a: zeigt einen Querschnitt durch ein fünftes Substrat, nach Erzeugung einer fünften MRAM-Zellenanordnung, bei der eine Speicherzelle einen vertikalen Transistor und ein Speicherelement umfaßt, wobei in Gräben jeweils zwei Gate-Leitungen erzeugt wurden.
- Figur 17b: zeigt ein Schaltbild der fünften MRAMZellenanordnung.
- Figur 18a: zeigt einen Querschnitt durch ein sechstes Substrat, nach Erzeugung einer sechsten MRAMZellenanordnung, bei der eine Speicherzelle einen vertikalen Transistor umfaßt, und bei der eine GateLeitung mit einer Schreibleitung elektrisch verbunden ist.
- Figur 18b: zeigt ein Schaltbild der sechsten MRAM-Zellenanordnung.
- Figur 19a: zeigt einen Querschnitt durch ein siebtes Substrat, nach Erzeugung einer siebten MRAM-Zellenanordnung, bei der eine Speicherzelle einen planaren Transistor umfaßt, und die Speicherzelle zwischen einer Schreibleitung und einer Bitleitung geschaltet ist.
- Figur 19b: zeigt ein Schaltbild der siebten MRAM-Zellenanordnung.
- Figur 20a: zeigt einen Querschnitt durch ein achtes Substrat, nach Erzeugung einer achten MRAM-Zellenanordnung, bei der eine Speicherzelle einen planaren Transistor umfaßt, bei der die Speicherzelle zwischen einer Schreibleitung und einer Bitleitung geschaltet ist und bei der die Schreibleitung mit einer Gate-Leitung elektrisch verbunden ist.
- Figur 20b: zeigt ein Schaltbild der achten MRAM-Zellenanordnung.

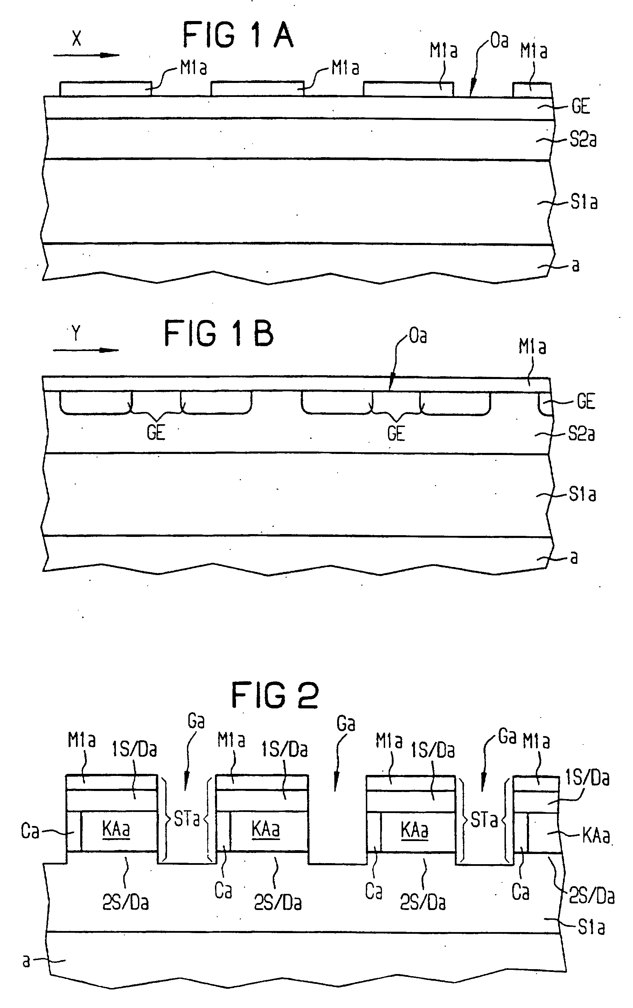

In einem ersten Ausführungsbeispiel ist ein erstes Substrat a eine Siliziumscheibe, die p-dotiert ist und eine Dotierstoffkonzentration von ca. 10¹⁵ cm⁻³ aufweist. Durch insitu dotierte Epitaxie wird eine ca. 500 nm dicke n-dotierte erste Schicht S1a erzeugt, die eine Dotierstoffkonzentration von ca. 5*10²⁰cm⁻³ aufweist. Darüber wird durch insitu dotierte Epitaxie eine ca. 450 nm dicke p-dotierte zweite Schicht S2a erzeugt, die eine Dotierstoffkonzentration von ca. 3*10¹⁷cm⁻³ aufweist siehe Figuren 1a und 1b).

Mit Hilfe einer ersten Fotolackmaske (nicht dargestellt), deren Streifen ca. 500 nm breit sind, einen Abstand von ca. 500 nm voneinander aufweisen und parallel zu einer x-Achse X verlaufen; werden durch Implantation ca. 100 nm dicke n-dotierte streifenförmige Gebiete GE erzeugt (siehe Figuren 1a und 1b). Die Dotierstoffkonzentration der streifenförmigen dotierten Gebiete GE beträgt ca. **5*x*10**^{**20**} ***cm***^{**-3**}. Deren Dotierstoff wird durch einen Temperschritt aktiviert. Die x-Achse x verläuft parallel zu einer Oberfläche Oa des ersten Substrats a.

Zur Erzeugung einer ersten Maske M1a wird SiO₂ in einem TEOS-Verfahren in einer Dicke von ca. 100 nm abgeschieden und durch ein fotolithographisches Verfahren streifenförmig strukturiert. Die Streifen der ersten Maske M1a verlaufen parallel zu einer y-Achse Y, die senkrecht zur x-Achse X und parallel zur Oberfläche Oa verläuft. Die Streifen der ersten Maske M1a sind ca. 750 nm breit und weisen einen Abstand von ca. 500 nm voneinander auf (siehe Figuren 1a und 1b).

Mit Hilfe der ersten Maske M1a wird Silizium mit z.B. HBr + NF₃ + He + O₂ ca. 600 nm tief geätzt, wodurch Gräben Ga entstehen. Die Gräben Ga durchtrennen die streifenförmigen dotierten Gebiete GE, und die zweite Schicht S2a und reichen bis in die erste Schicht Sla hinein. Zwischen den Gräben Ga entstehen streifenförmige Halbleiterstrukturen STa. Als Teile der Halbleiterstrukturen STa entstehen aus den streifenförmigen Gebieten GE erste Source/Drain-Gebiete 1S/Da von vertikalen Transistoren. Teile der zweiten Schicht S2a, die unterhalb der ersten Source/Drain-Gebiete 1S/Da angeordnet sind, sind als Kanalgebiete KAa geeignet. Teile der ersten Schicht Sla, die unterhalb der Kanalgebiete KAa angeordnet sind, sind als zweite Source/Drain-Gebiete 2S/Da geeignet. Die zweiten Source/Drain-Gebiete 2S/Da der Transistoren sind also elektrisch miteinander verbunden. Sie werden mit einem Spannungsanschluß verbunden.

Durch eine schräge Implantation mit Hilfe von p-dotierenden Ionen werden im Bereich der Kanalgebiete KAa und angrenzend an erste Flanken der Gräben Ga Channel-Stop-Gebiete Ca erzeugt (siehe Figur 2). Eine zur x-Achse X parallele Abmessung der Channel-Stop-Gebiete Ca beträgt ca. 100 nm. Die Dotierstoffkonzentration der Channel-Stop-Gebiete Ca beträgt ca. 10¹⁹cm⁻³.

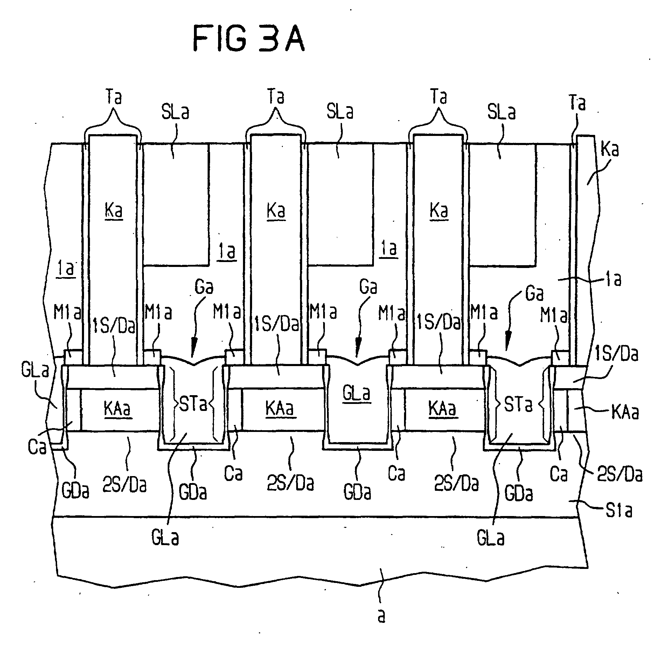

Durch thermische Oxidation wird ein ca. 10 nm dickes Gatedielektrikum GDa erzeugt (siehe Figur 3a). Zur Erzeugung von Gate-Leitungen GLa wird insitu n-dotiertes Polysilizium in einer Dicke von ca. 150 nm abgeschieden und mit z.B. C₂F₆ + O₂ ca. 200 nm zurückgeätzt. Dadurch entstehen die Gate-Leitungen GLa, die die Gräben Ga auffüllen. Teile der Gate-Leitungen GLa, die im Bereich der Kanalgebiete KAa angeordnet sind, sind als Gateelektroden der Transistoren geeignet.

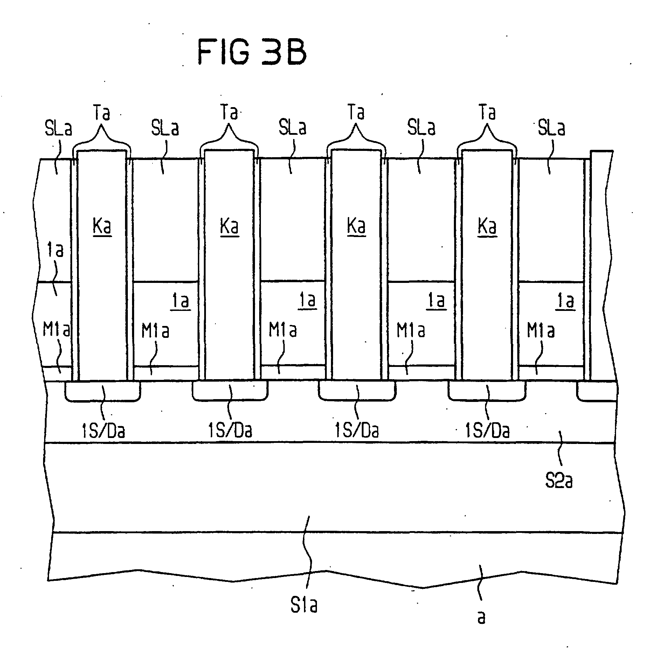

Durch Abscheiden von SiO₂ in einer Dicke von ca. 1500 nm und durch chemisch mechanisches Polieren bis auf eine Dicke von ca. 1000 nm, wird eine erste isolierende Schicht la erzeugt (siehe Figuren 3a und 3b).

Zur Erzeugung von Kontakten Ka werden in der ersten isolierenden Schicht la durch ein fotolithographisches Verfahren Kontaktlöcher geätzt, bis die ersten Source/Drain-Gebiete 1S/Da freigelegt werden. Als Ätzmittel ist z.B. CHF₃ + O₂, CHF₃+CF₄, C₄F₈+CO geeignet. Zur Erzeugung einer Trennschicht Ta an Seitenflächen der Kontaktlöcher wird Siliziumnitrid in einer Dicke von ca. 50 nm abgeschieden und rückgeätzt, wodurch die Trennschicht Ta in Form von Spacern entstehen. Als Ätzmittel ist z.B. CHF₃ + O₂ geeignet.

Durch Abscheiden von Wolfram in einer Dicke von ca. 500 nm und Rückätzen werden in den Kontaktlöchern die Kontakte Ka erzeugt. Als Ätzmittel ist z.B. SF₆ + H₂ + O₂ geeignet (siehe Figuren 3a und 3b).

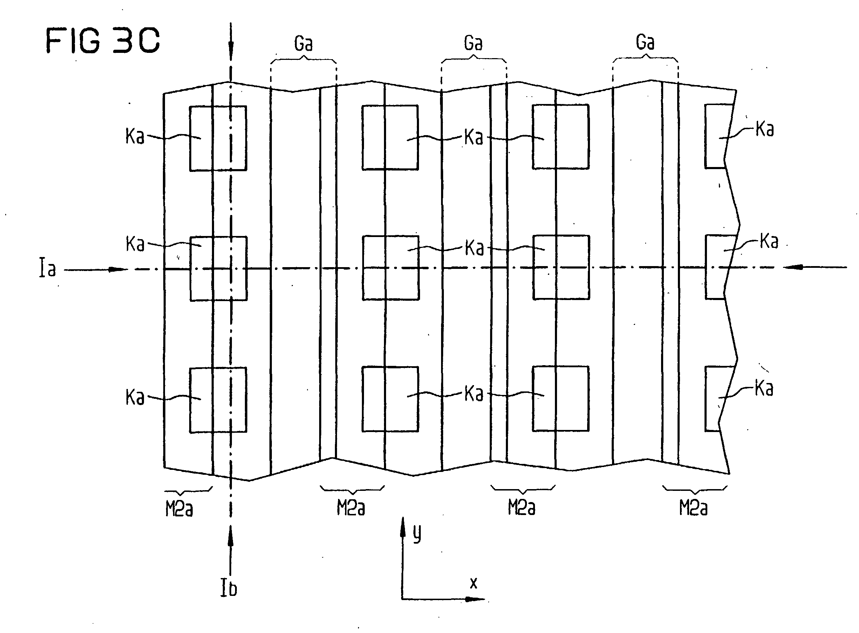

Aus Fotolack wird eine streifenförmige zweite Maske M2a erzeugt (siehe Figur 3c). Die Streifen der zweiten Maske M2a sind ca. 500 nm breit, weisen einen Abstand von ca. 750 nm voneinander auf, verlaufen parallel zur y-Achse Y und überlappen die Kontakte Ka teilweise. Mit Hilfe der zweiten Maske M2a wird SiO₂ selektiv zu Wolfram und Siliziumnitrid ca. 500 nm tief geätzt. Als Ätzmittel ist z.B. C₂F₆ + O₂ geeignet.

Dabei wird die Trennschicht Ta teilweise freigelegt. Nach Entfernung der zweiten Maske M2a wird Kupfer in einer Dicke von ca. 1 µm abgeschieden. Durch chemisch mechanisches Polieren wird Kupfer und ein Teil der ersten isolierenden Schicht 1a abgetragen, bis die Kontakte Ka aufgrund der größeren Härte von Wolfram ca. 50 nm herausragen (siehe Figuren 3a und 3b). Aus dem Kupfer entstehen Schreibleitungen SLa.

Zur Erzeugung einer Isolation Ia wird SiO₂ in einer Dicke von ca. 100 nm abgeschieden und durch chemisch mechanisches Polieren abgetragen, bis eine obere Fläche der Kontakte Ka freigelegt wird. Dadurch entsteht oberhalb der Schreibleitungen SLa die ca. 50 nm dicke Isolation Ia.

Zur Erzeugung einer ersten magnetischen Schicht F1a wird Co in einer Dicke von ca. 10 nm abgeschieden. Darüber wird zur Erzeugung eines Dielektrikums Ea Al₂O₃ erzeugt, indem Aluminium in einer Dicke von ca. 3 nm aufgebracht und in einem Plasma aufoxidiert wird. Zur Erzeugung einer zweiten magnetischen Schicht F2a wird NiFe in einer Dicke von 10 nm abgeschieden.

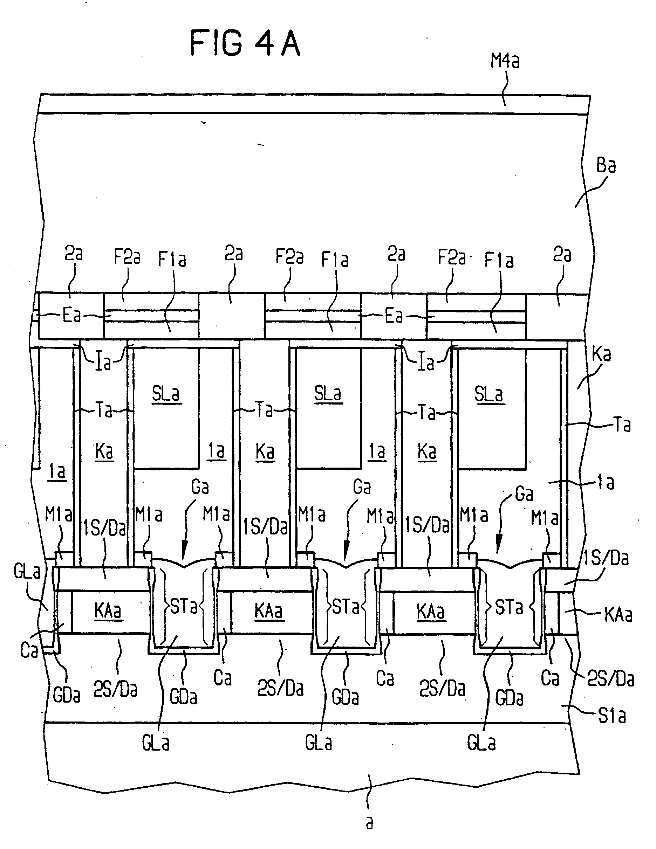

Mit Hilfe einer zur zweiten Maske M2a analogen dritten Maske aus Fotolack, werden die zweite magnetische Schicht F2a, das Dielektrikum Ea und die erste magnetische Schicht Fla geätzt. Dies kann z.B. durch Sputtern mit Ar erfolgen (siehe Figur 4a). Zur Erzeugung einer zweiten isolierenden Schicht 2a wird SiO₂ in einer Dicke von ca. 100 nm abgeschieden und durch chemisch-mechanisches Polieren planarisiert, bis die zweite magnetische Schicht F2a freigelegt wird.

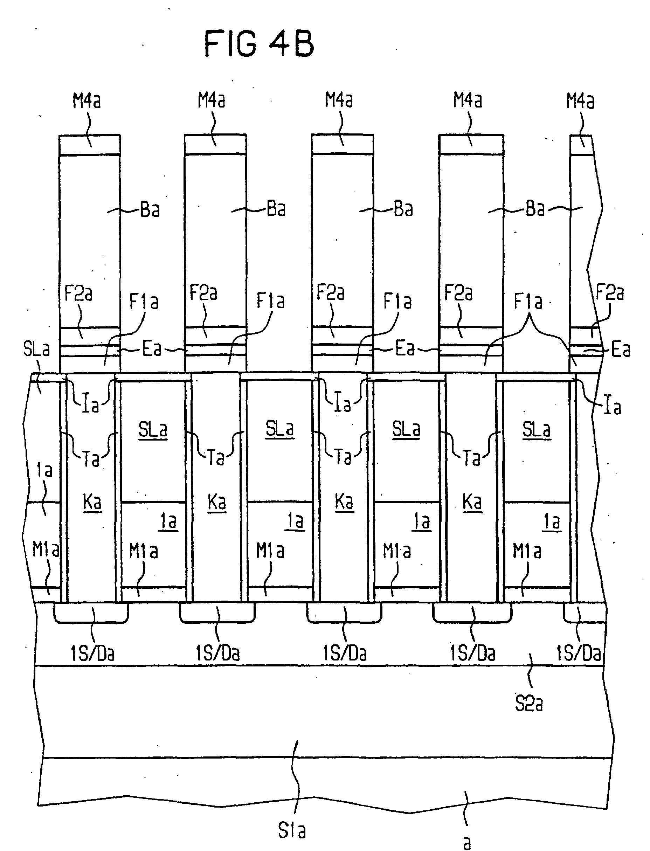

Zur Erzeugung von Bitleitungen Ba wird Kupfer in einer Dicke von ca. 500 nm abgeschieden. Zur Erzeugung einer vierten Maske M4a wird SiO₂ in einer Dicke von ca. 50 nm abgeschieden und durch ein fotolithographisches Verfahren streifenförmig strukturiert. Die Streifen der vierten Maske M4a sind ca. 500 nm breit, weisen einen Abstand von ca. 500 nm voneinander auf, bedecken die Kontakte Ka und verlaufen parallel zur x-Achse X. Mit Hilfe der vierten Maske M4a wird Kupfer mit z.B. BCl₃ + Cl₂ + CH₄ geätzt, wodurch die Bitleitungen Ba entstehen. Anschließend werden die zweite magnetische Schicht F2a, das Dielektrikum Ea und die erste magnetische Schicht F1a durchtrennt (siehe Figuren 4a und 4b). Dabei entstehen oberhalb der Schreibleitungen SLa Speicherelemente, die jeweils einen Teil der ersten magnetischen Schicht F1a, des Dielektrikums Ea und der zweiten magnetischen Schicht F2a umfassen.

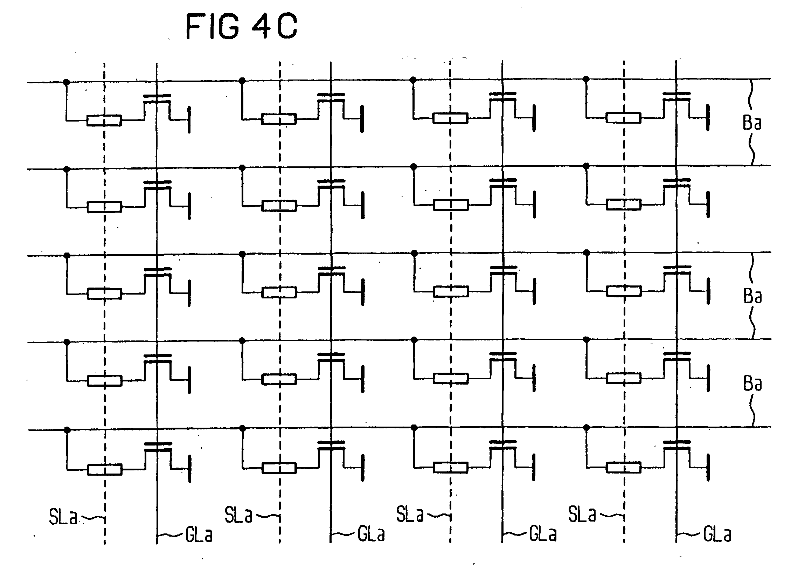

Durch das beschriebene Verfahren wird eine erste MRAM-Zellenanordnung erzeugt. Eine Speicherzelle umfaßt eines der Speicherelemente und einen der vertikalen Transistoren (siehe Figur 4c). Das Speicherelement und der Transistor sind in Reihe geschaltet. Die Speicherzelle ist zwischen der mit der zweiten magnetischen Schicht F2a verbundenen Bitleitung Ba und dem Spannungsanschluß (Ground)geschaltet (siehe Figur 4c). Zum Programmieren der Speicherzelle wird durch die Schreibleitung SLa, die die Speicherzelle durchquert, und durch die Bitleitung Ba jeweils ein Strom geschickt. Dabei wird ein Magnetfeld erzeugt, das in dem Speicherelement ein Schwellenfeld des zugehörigen Teils der zweiten magnetischen Schicht F2a überschreitet, wodurch seine Magnetisierung entsprechend dem Magnetfeld ausgerichtet wird. Das Magnetfeld ist kleiner als das Schwellenfeld des zugehörigen Teils der ersten magnetischen Schicht F1a, die härter als die zweite magnetische Schicht F2a ist, weshalb ihre Magnetisierungsrichtung erhalten bleibt. Da das Magnetfeld eine Überlagerung eines Magnetfeldes der Schreibleitung SLa und eines Magnetfeldes der Bitleitung Ba ist, und durch die übrigen Bitleitungen Ba und Schreibleitungen SLa keine Ströme fließen, ist das Magnetfeld im Speicherelement im Vergleich zu den übrigen Speicherelementen am größten. In den übrigen Speicherelementen ist das Magnetfeld kleiner als das Schwellenfeld der zweiten magnetischen Schicht F2a, weshalb die übrigen Speicherzellen nicht programmiert werden.

Zum Auslesen der Speicherzelle wird der Transistor über die mit ihm verbundene Gate-Leitung GLa angesteuert. Es wird der Strom gemessen, der zwischen der Bitleitung Ba und dem Spannungsanschluß fließt. Alternativ wird der Spannungsabfall zwischen der Bitleitung Ba und dem Spannungsanschluß gemessen. Der Strom oder die Spannung ist abhängig vom elektrischen Widerstand des Speicherelements. Aus dem Strom oder der Spannung kann also die Magnetisierungsrichtung des zugehörigen Teils der zweiten magnetischen Schicht F2a und damit die Information der Speicherzelle bestimmt werden.

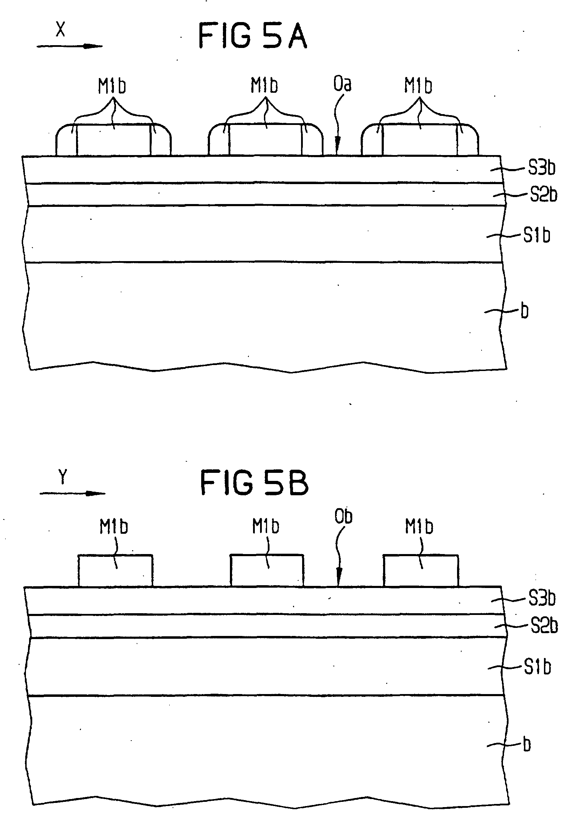

In einem zweiten Ausführungsbeispiel ist ein zweites Substrat b, eine p-dotierte Siliziumscheibe, dessen Dotierstoffkonzentration ca. 10¹⁷cm⁻³ beträgt. Durch insitu dotierte Epitaxie wird eine ca. 500 nm dicke n-dotierte erste Schicht S1b erzeugt; dessen Dotierstoffkonzentration ca. 5*10²⁰cm⁻³ beträgt. Darüber wird durch insitu dotierte Epitaxie eine ca. 350 nm dicke p-dotierte zweite Schicht S2b erzeugt, dessen Dotierstoffkonzentration ca. 3*10¹⁷cm⁻³ beträgt. Darüber wird durch insitu dotierte Epitaxie eine ca. 100 nm dicke n-dotierte dritte Schicht S3b erzeugt, dessen Dotierstoffkonzentration ca. 5*10²⁰cm⁻³ beträgt (siehe Figuren 5a und 5b).

Zur Erzeugung einer ersten Maske M1b wird in einem TEOS-Verfahren SiO₂ in einer Dicke von ca. 100 nm abgeschieden und durch ein fotolithographisches Verfahren mit einer ersten Fotolackmaske (nicht dargestellt) streifenförmig strukturiert. Die Streifen weisen eine Breite von ca. 500 nm und einen Abstand von ca. 500 nm voneinander auf und verlaufen parallel zu einer y-Achse Y. Durch Abscheiden von SiO₂ in einer Dicke von ca. 150 nm und Rückätzen werden an Flanken der Streifen Spacer erzeugt, wodurch die Streifen verbreitert werden. Die Breite der verbreiterten Streifen beträgt ca. 750 nm. Als Ätzmittel ist z.B. CHF₃ + O₂ geeignet. Mit Hilfe einer streifenförmigen zweiten Fotolackmaske (nicht dargestellt), deren Streifen parallel zu einer x-Achse X, die senkrecht zur y-Achse Y und parallel zu einer Oberfläche Ob des zweiten Substrats b verläuft, verlaufen, eine Breite von ca. 500 nm und einen Abstand von ca. 500 nm voneinander aufweisen, wird SiO₂ geätzt, wodurch aus den verbreiterten Streifen die erste Maske M1b entsteht (siehe Figuren 5a und 5b).

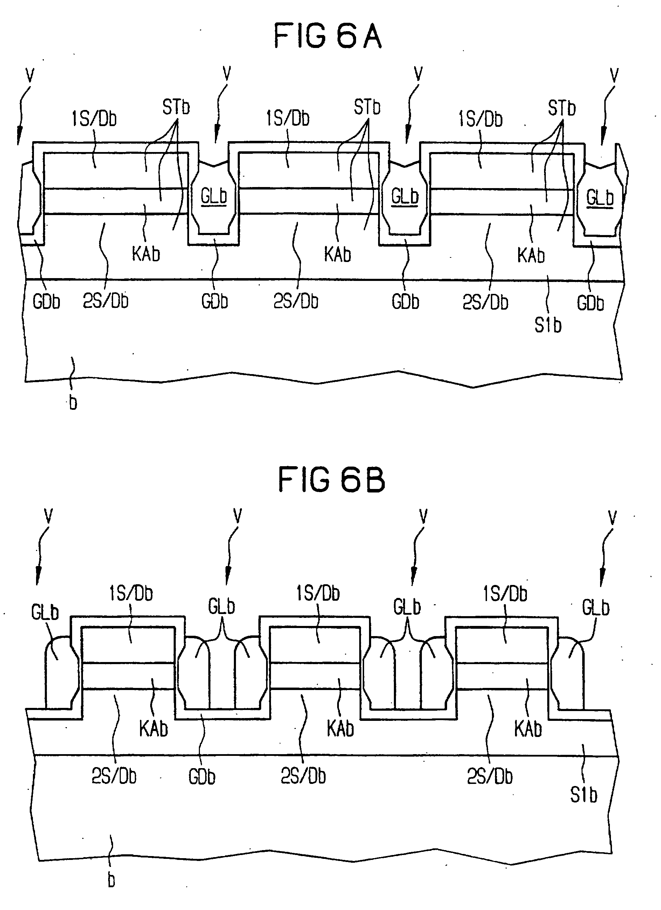

Mit Hilfe der ersten Maske M1b wird Silizium mit z.B. HBr + NF₃ + He + O₂ ca. 600 nm tief geätzt, wodurch eine gitterförmige Vertiefung V erzeugt wird. Die dritte Schicht S3b und die zweite Schicht S2b werden dabei durchtrennt. Es entstehen quaderförmige Halbleiterstrukturen STb. Als Teile der Halbleiterstrukturen STb entstehen aus der dritten Schicht S3b erste Source/Drain-Gebiete 1S/Db von vertikalen Transistoren und aus der zweiten Schicht S2b Kanalgebiete KAb der Transistoren. Unter den Kanalgebieten KAb angeordnete Teile der ersten Schicht S1b sind als zweite Source/Drain-Gebiete 25/Db der Transistoren geeignet. Die zweiten Source/Drain-Gebiete 2S/Db sind elektrisch miteinander verbunden (siehe Figuren 6a und 6b). Sie werden mit einem Spannungsanschluß elektrisch verbunden.

Durch Ätzen von SiO₂ mit z.B. CHF₃ + O₂ wird die erste Maske M1b entfernt.

Durch thermische Oxidation wird ein ca. 5 nm dickes Gatedielektrikum GDb erzeugt.

Durch Abscheiden von insitu dotiertem Polysilizium in einer Dicke von ca. 150 nm und Rückätzen entstehen in der gitterförmigen Vertiefung V selbstjustiert, d.h. ohne Verwendung von zu justierenden Masken, parallel zur x-Achse X verlaufende Gate-Leitungen GLb, die die Halbleiterstrukturen STb ringförmig umgeben (siehe Figuren 6a und 6b). Da Abstände zwischen entlang der x-Achse X benachbarten Halbleiterstrukturen STb kleiner sind als Abstände zwischen entlang der y-Achse Y benachbarten Halbleiterstrukturen STb wird das Gatedielektrikum GDb zwischen den entlang der x-Achse X benachbarten Halbleiterstrukturen STb nicht freigelegt. Die Gate-Leitungen GLb wirken als Gateelektroden der Transistoren. An zur x-Achse X parallele Flanken der Halbleiterstrukturen STb sind die Gate-Leitungen GLb spacerförmig.

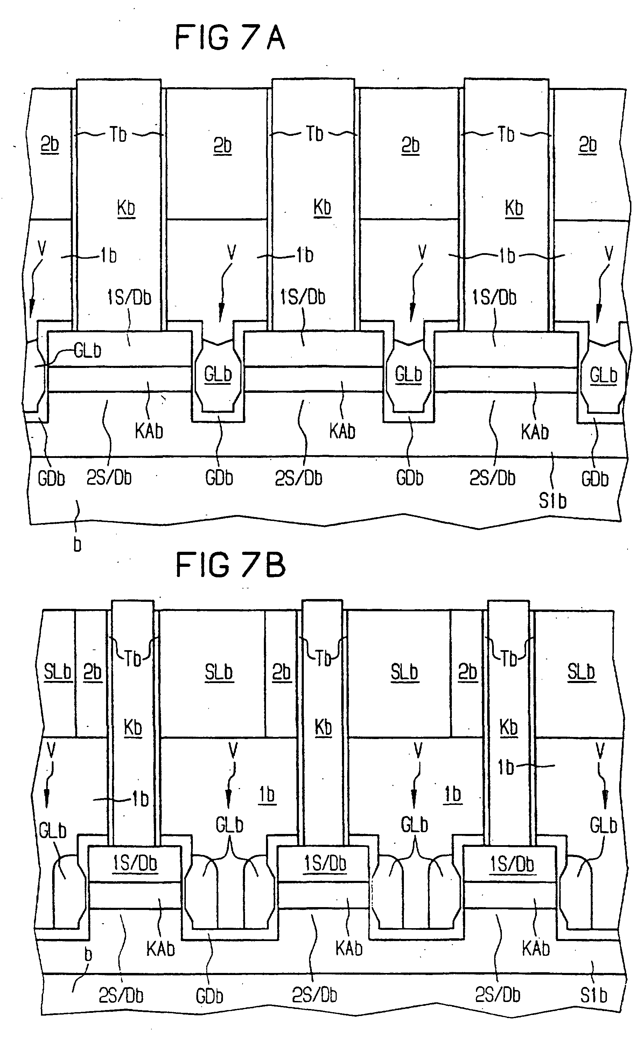

Zur Erzeugung einer ersten isolierenden Schicht 1b wird SiO₂ in einer Dicke von ca. 1500 nm abgeschieden und durch chemisch mechanisches Polieren bis auf eine Dicke von ca. 1000 nm reduziert. Zur Erzeugung von Schreibleitungen SLb wird Kupfer in einer Dicke von ca. 1 µm abgeschieden und durch ein fotolithographisches Verfahren mit z.B. BCl₃ + Cl₂ + CH₄ streifenförmig strukturiert. Die Streifen der Schreibleitungen SLb verlaufen parallel zur x-Achse X, sind ca. 500 nm breit und weisen einen Abstand von ca. 500 nm voneinander auf (siehe Figur 7b). Die Schreibleitungen sind versetzt aber nicht komplementär zur zweiten Fotolackmaske angeordnet.

Zur Erzeugung einer zweiten isolierenden Schicht 2b wird SiO₂ in einer Dicke von ca. 1 µm abgeschieden und durch chemisch mechanisches Polieren planarisiert, bis die obere Flächen der Schreibleitungen SLb freigelegt werden.

Mit Hilfe einer dritten Fotolackmaske (nicht dargestellt), die rechteckige Bereiche, die die Schreibleitungen SLb teilweise überlappen, nicht bedeckt, wird SiO₂ selektiv zu den Schreibleitungen SLb geätzt, bis die ersten Source/Drain-Gebiete 1S/Db freigelegt werden. Die erste isolierende Schicht 1b und die zweite isolierende Schicht 2b werden dabei durchtrennt. Die rechteckigen Bereiche sind so gewählt, daß Kontaktlöcher entstehen, die an den ersten Source/Drain-Gebieten 1S/Db enden (siehe Figuren 7a und 7b). Zur Erzeugung einer Trennschicht Tb wird Siliziumnitrid in einer Dicke von ca. 50 nm abgeschieden und rückgeätzt, wodurch die Trennschicht Tb an den Seitenflächen der Kontaktlöcher in Form vor. Spacern entstehen.

Anschließend wird Wolfram in einer Dicke von ca. 500 nm abgeschieden und rückgeätzt, wodurch die Kontaktlöcher mit Wolfram aufgefüllt werden und Kontakte Kb entstehen. Die Trennschicht Tb isoliert die Kontakte Kb von den Schreibleitungen SLb.

Durch chemisch mechanisches Polieren werden die Schreibleitungen SLb und die zweite isolierende Schicht 2b ca. 50 nm abgetragen. Die Kontakte Kb ragen aufgrund der größeren Härte von Wolfram ca. 50nm heraus (siehe Figuren 7a und 7b).

Zur Erzeugung einer Isolation Ib wird SiO₂ in einer Dicke von ca. 100 nm abgeschieden und durch chemisch mechanisches Polieren planarisiert, bis eine obere Fläche der Kontakte Kb freigelegt wird. Dadurch entsteht oberhalb der Schreibleitungen SLb die ca. 50 nm dicke Isolation Ib.

Analog wie im ersten Ausführungsbeispiel werden eine erste magnetische Schicht F1b und eine zweite magnetische Schicht F2b erzeugt, die durch ein fotolithographisches Verfahren streifenförmig strukturiert werden, wobei die Streifen parallel zur x-Achse X verlaufen, ca. 500 nm breit sind, einen Abstand von ca. 500 nm voneinander aufweisen und die Kontakte Kb sowie - getrennt durch die Isolation Ib - die Schreibleitungen SLb teilweise bedecken.

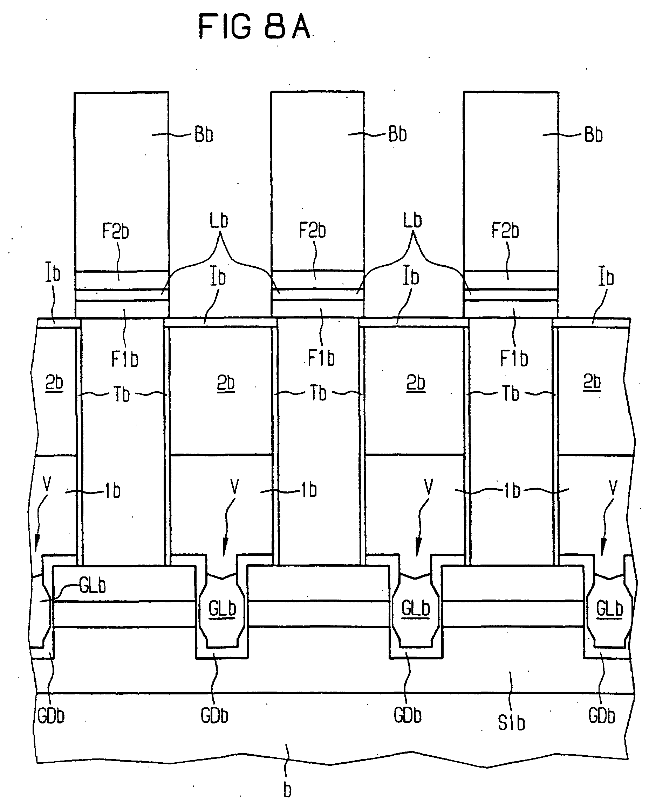

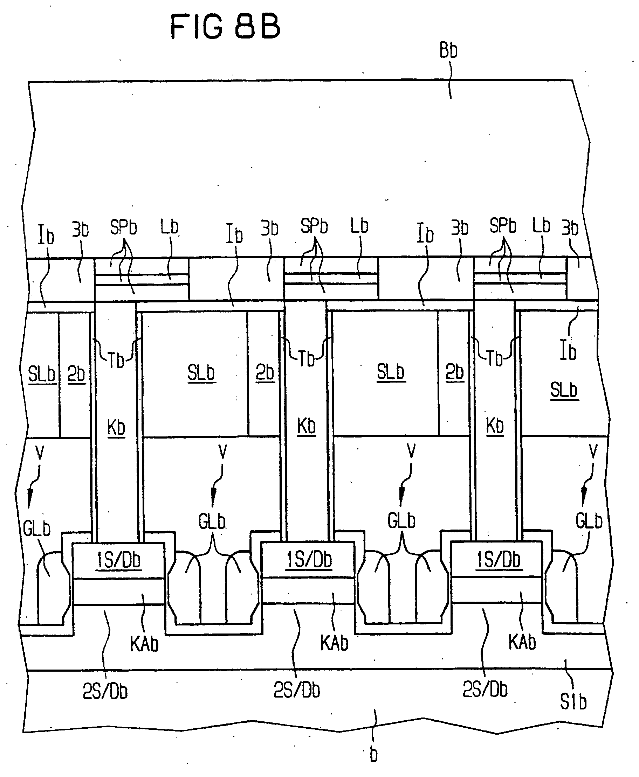

Wie im ersten Ausführungsbeispiel werden Bitleitungen Bb eine zur zweiten isolierenden Schicht 2a analoge dritte isolierte Schicht 3b und Speicherelemente SPb erzeugt, wobei die Bitleitungen Bb parallel zur y-Achse Y verlaufen (siehe Figur 8a und 8b) .

Durch das beschriebene Verfahren wird eine zweite MRAM-Zellenanordnung erzeugt. In einem dritten Ausführungsbeispiel ist ein Ausgangsmaterial ein drittes Substrat c aus Silizium, das p-dotiert ist und eine Dotierstoffkonzentration von ca. 10¹⁵cm⁻³ aufweist.

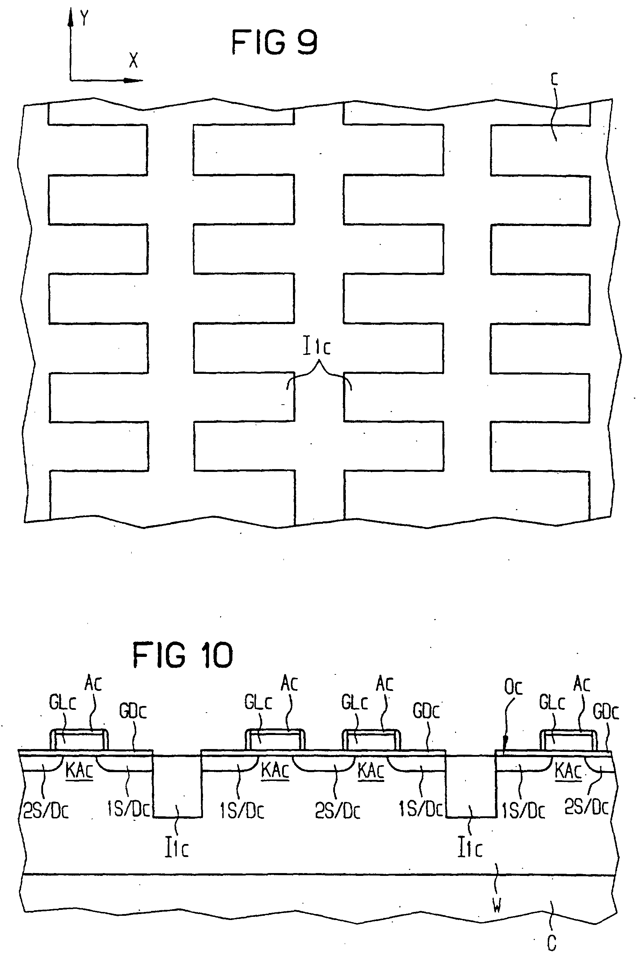

Durch ein fotolithographisches Verfahren werden Vertiefungen in das dritte Substrat c geätzt und mit SiO₂ aufgefüllt. Dadurch entsteht eine isolierende Struktur Ilc. Die isolierende Struktur I1c umfaßt parallel zu einer x-Achse X verlaufende Streifen sowie parallel zu einer y-Achse Y verlaufende Streifen. Die x-Achse X verläuft senkrecht zur y-Achse Y. Die parallel zur y-Achse Y verlaufenden Streifen sind ca. 500 nm breit und weisen einen Abstand von ca. 2,5 µm voneinander auf. Die parallel zur x-Achse X verlaufenden Streifen sind ca. 500 nm breit und weisen einen Abstand von ca. 500 nm voneinander auf. Die parallel zur x-Achse X verlaufenden Streifen sind nicht durchgängig, sondern in regelmäßig angeordnete Abschnitte unterteilt. Die Abschnitte sind jeweils 2,5 µm lang. Die parallel zur y-Achse Y verlaufenden Streifen kreuzen die Mitten der Abschnitte (siehe Figur 9). Die isolierende Struktur I1c ist ca. 500 nm tief.

Durch Implantation mit p-dotierenden Ionen wird in dem dritten Substrat c eine ca. 500 nm tiefe Wanne W erzeugt, die eine Dotierstoffkonzentration von ca. 3*10¹⁷cm⁻³ aufweist. Ihr Dotierstoff wird durch einen Temperschritt aktiviert.

Durch thermische Oxidation wird ein ca. 10 nm dickes Gatedielektrikum GDc auf einer Oberfläche Oc des dritten Substrats c erzeugt.

Anschließend wird auf der Oberfläche Oc Wolframsilizid in einer Dicke von ca. 200 nm erzeugt und darüber Siliziumnitrid in einer Dicke von ca. 100 nm abgeschieden, das zusammen mit dem Wolframsilizid durch ein fotolithographisches Verfahren mit Hilfe einer ersten Fotolackmaske (nicht dargestellt) streifenförmig strukturiert wird. Aus dem Wolframsilizid entstehen dabei zu der y-Achse Y parallel Gate-Leitungen GLc, die jeweils ca. 500 nm breit sind. Jeweils zwei Gate-Leitungen GLc sind zwischen den parallel zur y-Achse Y verlaufenden Streifen der isolierenden Struktur I1c angeordnet und weisen einen Abstand von ca. 500 nm voneinander auf (siehe Figur 10. Anschließend wird Siliziumnitrid in einer Dicke von ca. 100 nm abgeschieden und rückgeätzt, wodurch an Flanken der Gate-Leitungen GLc Spacer entstehen, die zusammen mit dem Siliziumnitrid auf den Gate-Leitungen GLc Ätzstop-Strukturen Ac bilden (siehe Figur 10).

Anschließend wird eine Implantation mit n-dotierenden Ionen durchgeführt, wobei die Gate-Leitungen GLc als Maske wirken. Dabei entstehen erste Source/Drain-Gebiete 1S/D1c und zweite Source/Drain-Gebiete 2S/Dc von planaren Transistoren (siehe Figur 10). Jeweils zwischen den beiden zueinander benachbarten Gate-Leitungen GLc, die zwischen den entlang der y-Achse Y verlaufenden Streifen der ersten isolierenden Struktur I1c angeordnet sind, entstehen die zweiten Source/Drain-Gebiete 2S/Dc. Die ersten Source/Drain-Gebiete 1S/Dc und die zweiten Source/Drain-Gebiete 2S/Dc sind ca. 100 nm tief. Unterhalb der Gate-Leitungen GLc und zwischen jeweils einem ersten Source/Drain-Gebiet 1S/Dc und einem zweiten Source/Drain-Gebiet 2S/Dc liegende Teile der Wanne W wirken als Kanalgebiete KAc der Transistoren. Über den Kanalgebieten KAc angeordnete Teile der Gate-Leitungen GLc wirken als Gateelektroden der Transistoren. Zweite Source/Drain-Gebiete 2S/Dc von entlang der y-Achse Y benachbarten Transistoren bilden ein gemeinsames streifenförmiges dotiertes Gebiet und sind folglich elektrisch miteinander verbunden. Zweite Source/Drain-Gebiete 2S/Dc von jeweils zwei Transistoren, die entlang der x-Achse X zueinander benachbart sind und zwischen benachbarten entlang der y-Achse Y verlaufenden Streifen der ersten isolierenden Struktur I1c angeordnet sind, fallen zusammen.

Zur Erzeugung einer ersten isolierenden Schicht 1c wird SiO₂ in einer Dicke von ca. 1,5 µm abgeschieden und durch chemisch mechanisches Polieren bis auf eine Dicke von ca. 1 µm reduziert. Durch ein fotolithographisches Verfahren werden über den ersten Source/Drain-Gebieten 1S/Dc Kontaktlöcher erzeugt. Als Ätzmittel ist z.B. CHF₃ + O₂ geeignet.

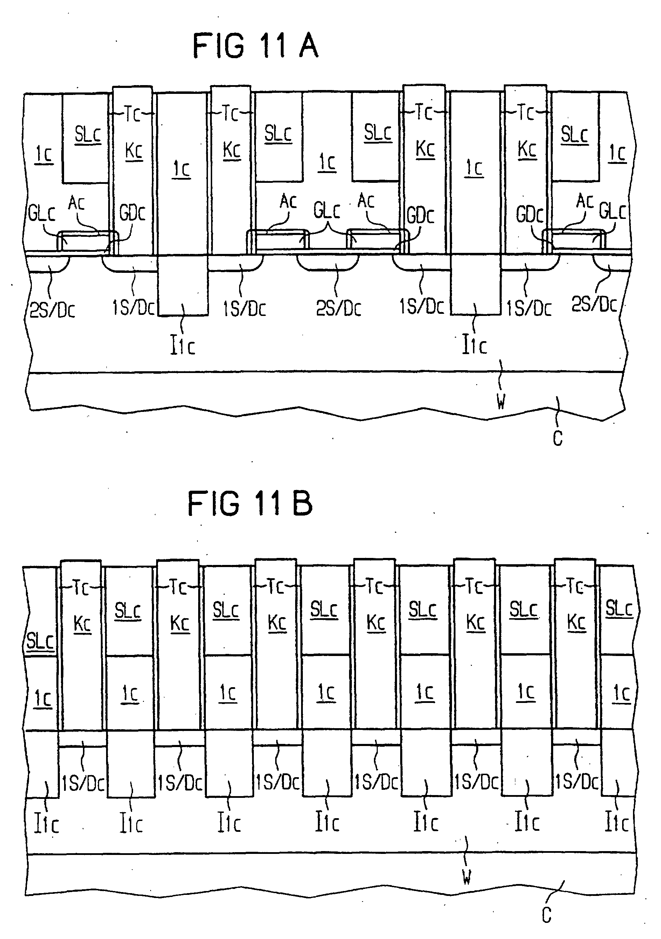

Zur Erzeugung einer Trennschicht Tc wird Siliziumnitrid in einer Dicke von ca. 50 nm abgeschieden und rückgeätzt, wodurch die Trennschicht Tc spacerförmig an Seitenflächen der Kontaktlöcher entstehen (siehe Figuren 11a und 11b). Anschließend wird Wolfram in einer Dicke von ca. 500 nm abgeschieden und rückgeätzt, wodurch die Kontaktlöcher gefüllt werden und Kontakte Kc erzeugt werden, die die ersten Source/Drain-Gebiete 1S/Dc kontaktieren. Als Ätzmittel ist z.B. SF₆ + H₂ + O₂ geeignet (siehe Figuren 11a und 11b).

Mit Hilfe einer streifenförmigen zweiten Fotolackmaske (nicht dargestellt wird SiO₂ selektiv zu Wolfram und Siliziumnitrid ca. 500 nm tief mit z.B. C₂S₆ + O₂ geätzt. Die Streifen der zweiten Fotolackmaske sind im wesentlichen komplementär zu den Streifen der für die Erzeugung der Gate-Leitungen GLc vorgesehenen ersten Fotolackmaske, mit dem Unterschied, daß die Streifen etwas dünner sind und deshalb die Kontakte Kc teilweise freiliegen.

Anschließend wird Kupfer in einer Dicke von ca. 1 µm abgeschieden, wodurch - getrennt durch die Trennschicht Tc - angrenzend an die Kontakte Kc Schreibleitungen SLc erzeugt werden.

Durch chemisch mechanisches Polieren werden Kupfer und SiO₂ abgetragen, bis die Kontakte Kc aufgrund ihrer größeren Härte ca. 50 nm herausragen (siehe Figuren 11a und 11b).

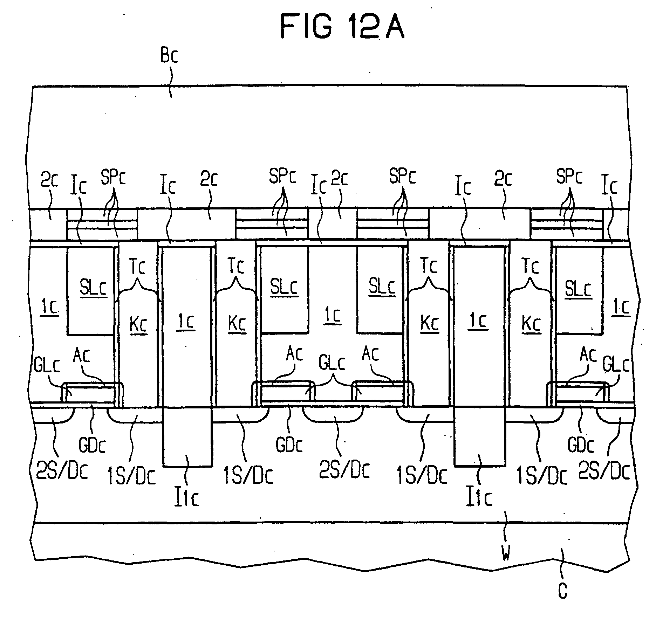

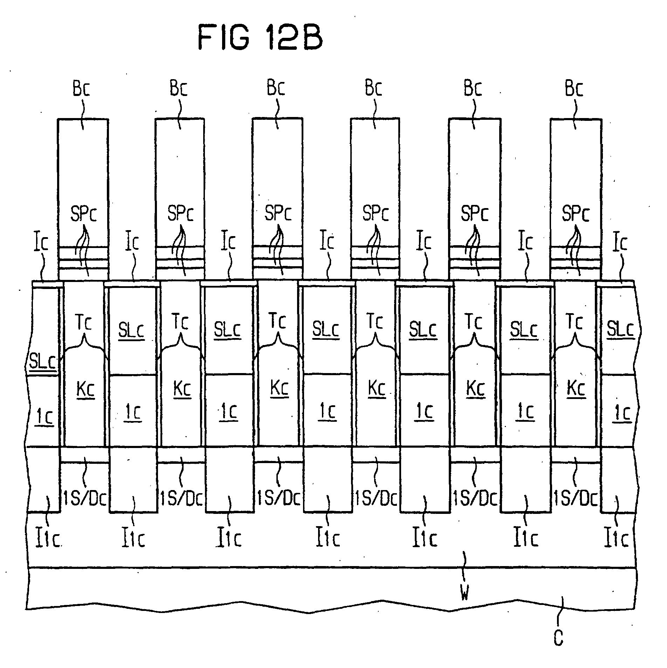

Anschließend werden analog wie in den vorhergehenden beiden Ausführungsbeispielen eine Isolation Ic, Speicherelemente SPc, eine zweite isolierende Schicht 2c und parallel zur x-Achse X verlaufende Bitleitungen Bc erzeugt (siehe Figuren 12a und 12b .

Durch das beschriebene Verfahren wird eine dritte MRAM-Zellenanordnung erzeugt. In einem vierten Ausführungsbeispiel ist ein viertes Substrat d eine Siliziumscheibe, die p-dotiert ist und eine Dotierstoffkonzentration von ca. 10¹⁵cm⁻-³ aufweist. Analog wie im ersten Ausführungsbeispiel werden eine erste Schicht S1d, eine zweite Schicht S2d, streifenförmige dotierte Gebiete, eine erste Maske M1d, senkrecht zu einer x-Achse X verlaufende Gräben Gd, streifenförmige Haibleiterstrukturen STd, erste Source/Drain-Gebiete 1S/Dd, Kanalgebiete KAd, zweite Source/Drain-Gebiete 2S/Dd, Channel-Stop-Gebiete Cd, ein Gatedielektrikum GDd und Gate-Leitungen GLd erzeugt.

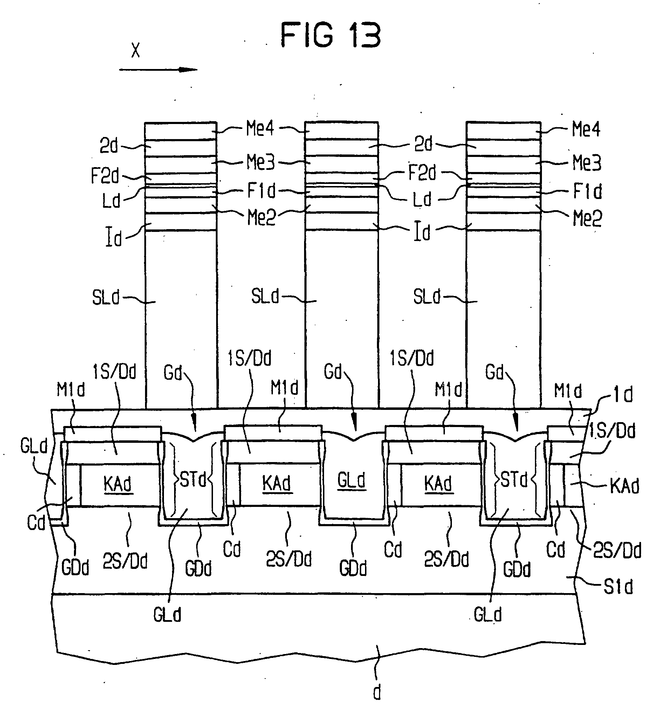

Zur Erzeugung einer ersten isolierenden Schicht 1d wird SiO₂ in einer Dicke von ca. 1µm abgeschieden und durch chemisch mechanisches Polieren bis auf eine Dicke von ca. 500 nm planarisiert (siehe Figur 13). Anschließend werden eine erste Metallschicht aus AlSiCu in einer Dicke von ca. 1 µm, darüber eine ca. 20 nm dicke Isolation Id aus SiO₂, darüber eine ca. 20 nm dicke zweite Metallschicht Me2 aus Wolfram, darüber eine ca. 10 nm erste magnetische Schicht F1d aus Co, darüber ein ca. 3 nm dickes Dielektrikum Ed aus Al₂O₃, darüber eine ca. 10 nm dicke zweite magnetische Schicht F2d aus NiFe, darüber eine ca. 20 nm dicke dritte Metallschicht Me3 aus Wolfram, darüber eine ca. 20 nm dicke zweite isolierende Schicht 2d aus SiO₂ und darüber eine ca. 20 nm dicke vierte Metallschicht Me4 aus Wolfram erzeugt. Mit Hilfe einer streifenförmigen Fotolackmaske (nicht dargestellt), deren Streifen etwas versetzt zu den Gräben Gd verlaufen, werden sämtliche oben aufgezählten Schichten bis einschließlich der ersten Metallschicht durchtrennt. Dabei entstehen aus der ersten Metallschicht parallel zur y-Achse Y verlaufende Schreibleicungen SLd (siehe Figur 13).

Zur Erzeugung einer dritten isolierenden Schicht 3d wird SiO₂ in einer Dicke von ca. 500 nm abgeschieden und durch chemisch mechanisches Polieren planarisiert, bis die dritte Metallschicht Me3, die als Ätzstop wirkt, freigelegt wird.

Zur Erzeugung einer vierten isolierenden Schicht 4d wird SiO₂ in einer Dicke von ca. 20 nm abgeschieden.

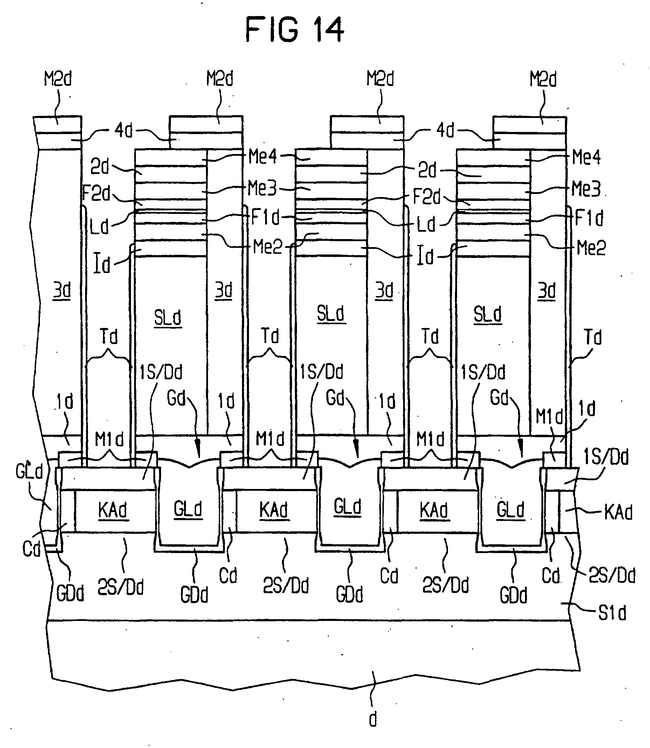

Anschließend wird eine Maske aus Wolfram M2d erzeugt, indem Wolfram in einer Dicke von ca. 20 nm abgeschieden und fotolithographisch strukturiert wird. Die Maske aus Wolfram M2d bedeckt rechteckige Bereiche nicht. Die rechteckigen Bereiche sind so angeordnet, daß beim nachfolgenden Ätzen von SiO₂ ein Teil der vierten Metallschicht Me4 sowie die ersten Source/Drain-Gebiete 1S/Dd freigelegt werden (siehe Figur 14).

Zur Erzeugung einer Trennschicht Td wird SiO₂ in einer Dicke von ca. 50 nm abgeschieden und rückgeätzt, bis die zweite Metallschicht Me2, die als Ätzstop wirkt, freigelegt wird, aber die Schreibleitungen SLd nicht freigelegt werden (siehe Figur 14).

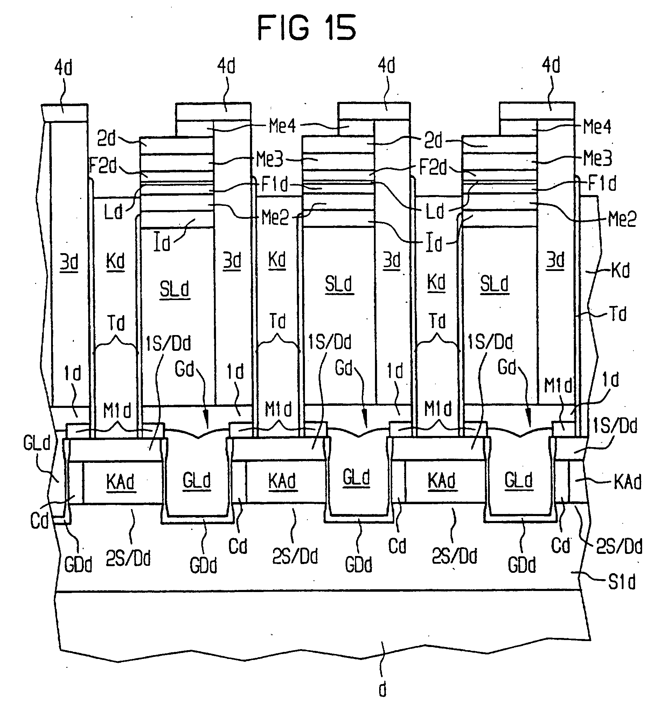

Zur Erzeugung von Kontakten Kd wird anschließend Wolfram in einer Dicke von ca. 500 nm abgeschieden und durch chemisch mechanisches Polieren planarisiert, bis die vierte isolierende Schicht 4d freigelegt wird. Dabei wird die Maske aus Wolfram M2d entfernt. Anschließend wird Wolfram selektiv zu SiO₂ rückgeätzt, bis eine obere Fläche der entstehenden Kontakte Kd im Bereich der zweiten Metallschicht Me2 liegt, wobei die vierte isolierende Schicht 4d als Maske wirkt. Dabei wird ein Teil der vierten Metallschicht Me4 entfernt. Die Kontakte Kd verbinden jeweils ein erstes Source/Drain-Gebiet 1S/Dd mit einem Teil der zweiten Metallschicht Me2 (siehe Figur 15).

Zur Erzeugung einer fünften isolierenden Schicht 5d wird SiO₂ in einer Dicke von ca. 500 nm abgeschieden und durch chemisch mechanisches Polieren planarisiert, bis eine obere Fläche der vierten Metallschicht Me4 freigelegt wird. Mit Hilfe von SF₆ + H₂ + O₂ wird die vierte Metallschicht Me4 entfernt.

Anschließend wird SiO₂ durch chemisch mechanisches Polieren planarisiert, bis eine obere Fläche der dritten Metallschicht Me3 freigelegt wird. Dabei wird die zweite isolierende Schicht 2d entfernt.

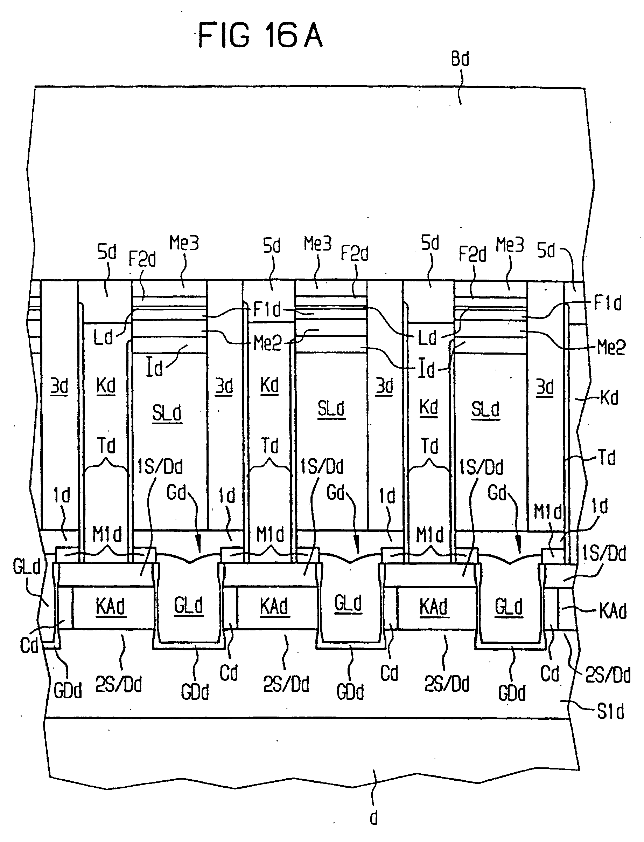

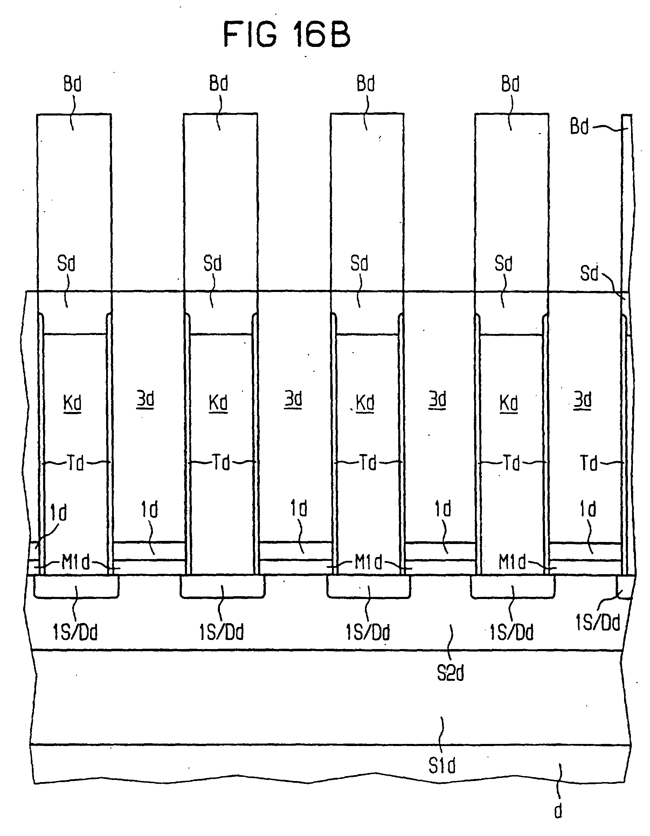

Zur Erzeugung von Bitleitungen Bd wird AlSiCu in einer Dicke von ca. 1 µm abgeschieden und zusammen mit der dritten Metallschicht Me3, der zweiten magnetischen Schicht F2d, dem Dielektrikum Ed, der ersten magnetischen Schicht F1d und der zweiten Metallschicht Me2 qeätzt. Dabei entstehen Speicherelemente, die jeweils einen Teil der zweiten Metallschicht Me2, einen darüber angeordneten Teil der ersten magnetischen Schicht F1d, einen darüber angeordneten Teil des Dielektrikums Ed, einen darüber angeordneten Teil der zweiten magnetischen Schicht F2d und einen darüber angeordneten Teil der dritten Metallschicht Me3 umfassen. Die Schreibleitungen SLd sind durch die Isolation Id von den Speicherelementen getrennt (siehe Figuren 16a und 16b).

Durch das beschriebene Verfahren wird eine vierte MRAM-Zellenanordnung erzeugt. Zur Verbindung mit den Transistoren sind die Speicherelemente von der Seite kontaktiert.

In einem fünften Ausführungsbeispiel ist ein fünftes Substrat e eine Siliziumscheibe, die p-dotiert ist und eine Dotierstoffkonzentration von ca. 10¹⁵cm⁻³ aufweist. Analog wie im vierten Ausführungsbeispiel werden eine erste Schicht S1e, eine zweite Schicht, streifenförmige dotierte Gebiete, eine erste Maske M1e, Gräben Ge, Halbleiterstrukturen STe, erste Source/Drain-Gebiete 1S/De, Kanalgebiete KAe und zweite Source/Drain-Gebiete 2S/De erzeugt.

Mit Hilfe einer streifenförmigen ersten Fotolackmaske, deren Streifen jedes zweite streifenförmige Gebiet bedeckt, werden erste Flanken der Gräben Ge durch schräge Implantation dotiert. Dabei entstehen p-dotierte Channel-Stop-Gebiete Ce. Mit Hilfe einer streifenförmigen zweiten Fotolackmaske, die die vorher nicht bedeckten streifenförmigen Gebiete bedeckt, werden durch schräge Implantation die zweiten Flanken der Gräben Ge implantiert. Dabei entstehen weitere Channel-Stop-Gebiete Ce. Die Dotierstoffkonzentration der Channel-Stop-Gebiete Ce beträgt ca. 10¹⁹cm⁻³. Entlang eines der Gräben Ge benachbarte Channel-Stop-Gebiete Ce sind alternierend an der ersten Flanke und an der zweiten Flanke des Grabens Ge angeordnet.

Durch thermische Oxidation wird ein ca. 10 nm dickes Gatedielektrikum GDe erzeugt.

Zur Erzeugung von Gate-Leitungen GLe wird insitu n-dotiertes Polysilizium in einer Dicke von ca. 150 nm abgeschieden und rückgeätzt, bis die Gate-Leitungen GLe in Form von Spacern an den ersten Flanken und an den zweiten Flanken der Gräben Ge entstehen. Teile der Gate-Leitungen GLe, die in Bereichen der Kanalgebiete KAe angeordnet sind, wirken als Gateelektroden der Transistoren.

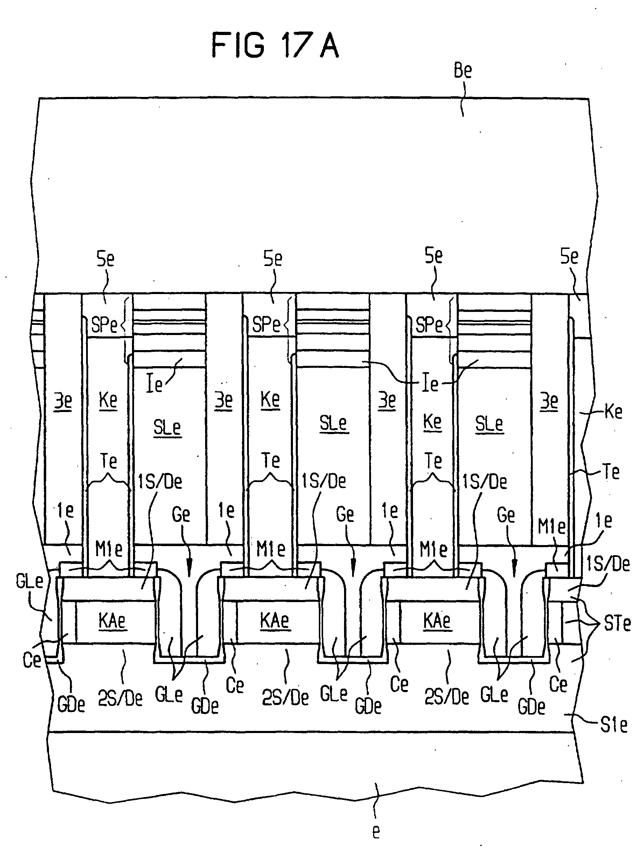

Anschließend werden analog wie im vierten Ausführungsbeispiel isolierende Schichten le, 3e, 5e, Schreibleitungen SLe, eine Isolation Ie, Speicherelemente SPe, Kontakte Ke, Trennschichten Te und Bitleitungen Be erzeugt (siehe Figur 17a).

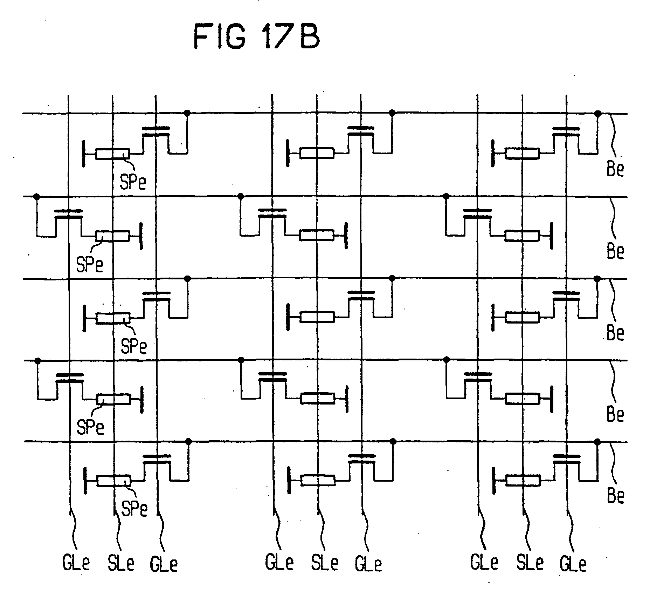

Durch das beschriebene Verfahren wird eine fünfte MRAM-Zellenanordnung erzeugt. Die fünfte MRAM-Speicherzellenanordnung hat folded Bitleitungen Be, da die alternierende Anordnung der Channel-Stop-Gebiete Ce gewährleistet, daß entlang des Grabens Ge benachbarte Speicherzellen, d.h. Speicherzellen, die mit zueinander benachbarten Bitleitungen Be verbunden sind, nicht von derselben Gate-Leitung GLe angesteuert werden (siehe Figur 17b).

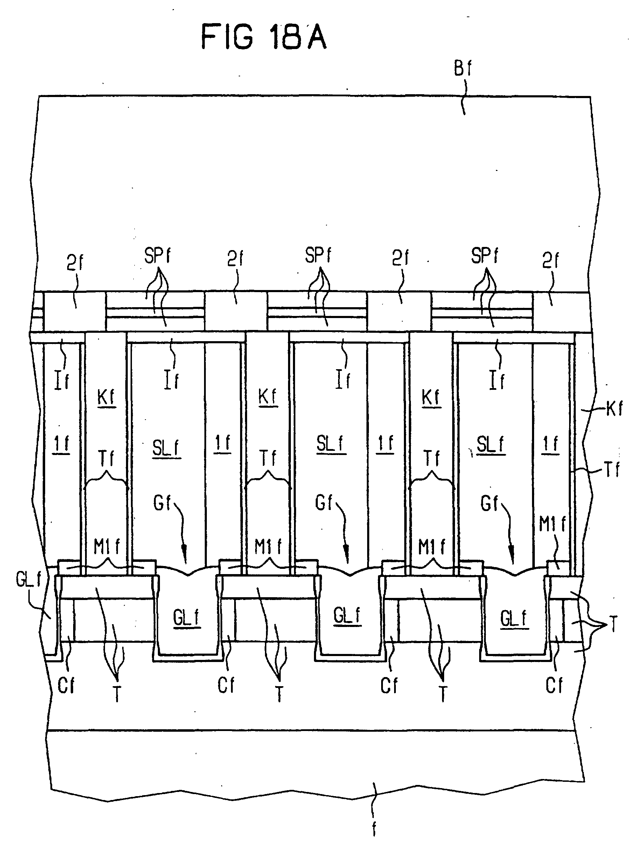

In einem sechsten Ausführungsbeispiel werden analog wie im ersten Ausführungsbeispiel ausgehend von einem sechsten Substrat f eine erste Maske M1f, Gräben Gf, vertikale Transistoren T, Channel-Stop-Gebiete Cf, Gate-Leitungen GLf, Schreibleitungen SLf, Trennschichten Tf, Kontakte Kf und eine erste isolierende Schicht 1f mit dem Unterschied erzeugt, daß die erste Maske M1f aus Siliziumnitrid erzeugt wird. Bei der Erzeugung der Schreibleitungen SLf wird im Gegensatz zum ersten Ausführungsbeispiel geätzt, bis die Gate-Leitungen GLf freigelegt werden. Durch Auffüllen mit Kupfer entstehen die Schreibleitungen SLf angrenzend an die Gate-Leitungen GLf. Analog wie im ersten Ausführungsbeispiel werden eine Isolation If, Speicherelemente SPf, eine zweite isolierende Schicht 2f und Bitleitungen Bf erzeugt (siehe Figur 18a).

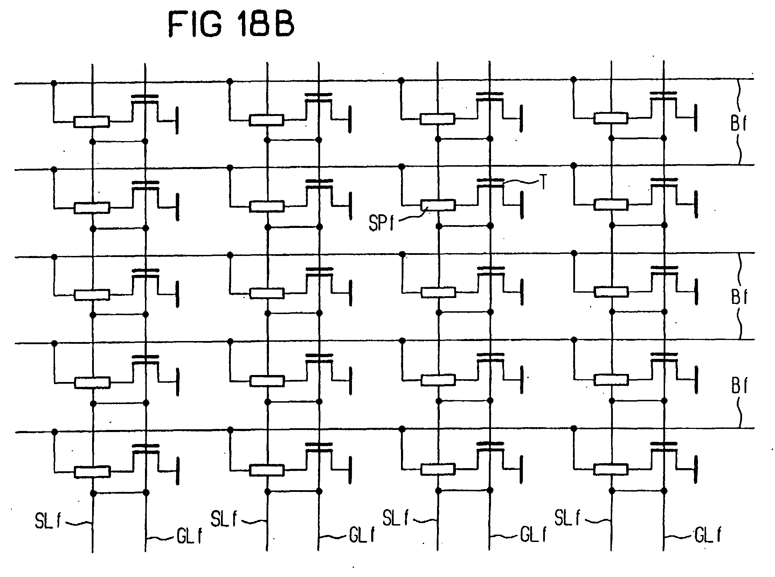

Durch das beschriebene Verfahren wird eine sechste MRAM-Zellenanordnung erzeugt. Beim Programmieren einer der Speicherzellen, wird der zugehörige Transistor T angesteuert, da die zugehörige Schreibleitung SLf mit der Gate-Leitung GLf des Transistors T elektrisch verbunden ist (siehe Figur 18b).

In einem siebten Ausführungsbeispiel ist ein siebtes Substrat g eine Siliziumscheibe, die p-dotiert ist und eine Dotierstoffkonzentration von ca. 10¹⁵ ***cm***^{**-3**} aufweist. Zur Erzeugung einer isolierenden Struktur I1g werden durch ein fotolithographisches Verfahren Vertiefungen erzeugt, die mit SiO₂ aufgefüllt werden. Die isolierende Struktur I1g weist parallel zu einer y-Achse verlaufende Streifen sowie parallel zu eine x-Achse X verlaufende Streifen auf. Die y-Achse verläuft senkrecht zur x-Achse X, die beide parallel zu einer Oberfläche Og des siebten Substrats g verlaufen. Die parallel zur y-Achse verlaufenden Streifen der isolierenden Struktur I1g weisen eine Breite von ca. 500 nm und einen Abstand von ca. 1500 nm voneinander auf. Die parallel zur x-Achse X verlaufenden Streifen der Struktur I1g weisen eine Breite von ca. 500 nm und einen Abstand von ca. 500 nm voneinander auf.

Ähnlich wie im dritten Ausführungsbeispiel werden planare Transistoren, parallel zur y-Achse verlaufende Gate-Leitungen GLg und Ätzstop-Strukturen Ag erzeugt, wobei jeweils ein Transistor zwischen zwei zueinander benachbarten parallel zu der y-Achse Y verlaufenden Streifen der isolierenden Struktur I1g angeordnet sind.

Nach Erzeugung der Ätzstop-Strukturen Ag wird zur Erzeugung einer ersten isolierenden Schicht 1g SiO₂ in einer Dicke von ca. 1 µm abgeschieden und durch chemisch mechanisches Polieren planarisiert. Durch ein fotolithographisches Verfahren werden Kontaktlöcher bis zu jeweils einem ersten Source/Drain-Gebiet 1S/Dg der Transistoren erzeugt. Die Kontaktlöcher werden zur Erzeugung von tiefen Kontakten KTg anschließend mit Wolfram gefüllt. Zur Erzeugung einer zweiten isolierenden Schicht 2g wird SiO₂ in. einer Dicke von ca. 1 µm abgeschieden und planarisiert.

Wie im dritten Ausführungsbeispiel werden über zweiten Source/Drain-Gebieten 2S/Dg der Transistoren Kontakte Kg erzeugt, die an den Seitenflächen mit einer Trennschicht Tg versehen sind.

Ähnlich wie im dritten Ausführungsbeispiel werden Schreibleitungen SLg erzeugt, mit dem Unterschied, daß die Schreibleitungen SLg so breit sind, daß sie die tiefen Kontakte KTg überlappen. Die ersten Source/Drain-Gebiete 1S/Dg sind also mit den Schreibleitungen SLg verbunden.

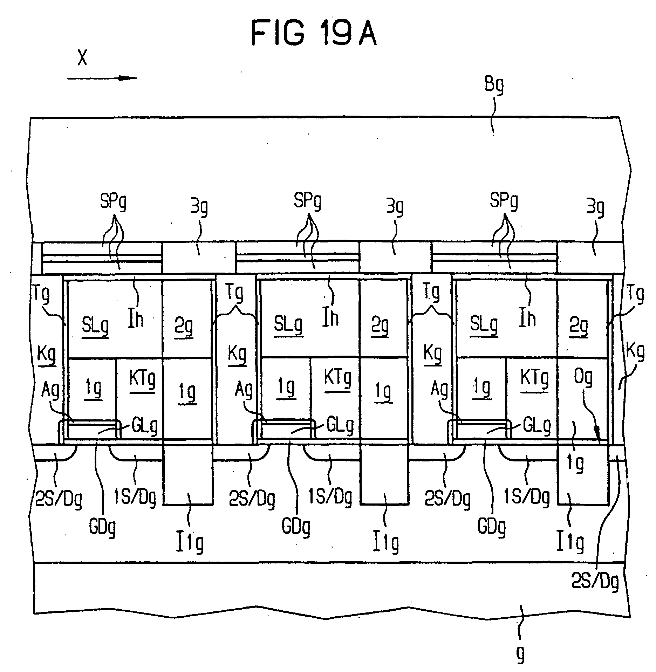

Analog wie in den vorangegangenen Ausführungsbeispielen werden eine Isolation Ig, Speicherelemente SPg, eine dritte isolierende Schicht Sg und Bitleitungen Bg erzeugt (siehe Figur 19a).

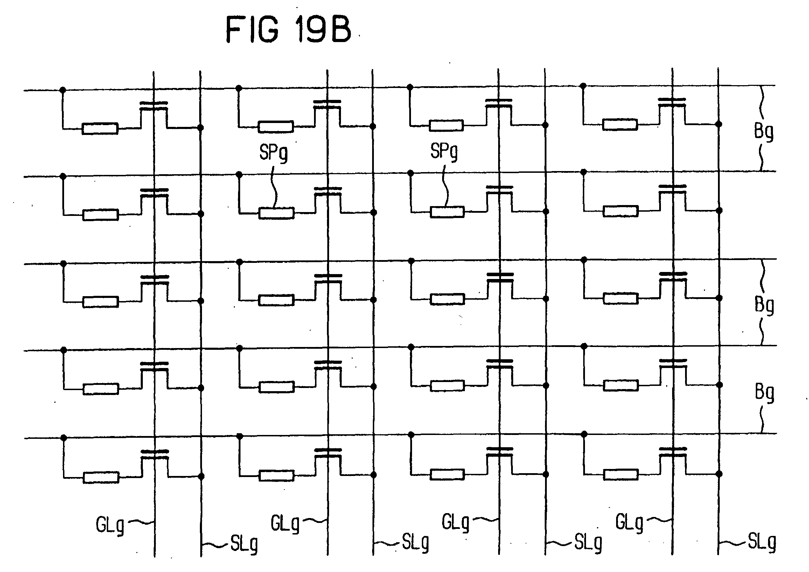

Durch das beschriebene Verfahren wird eine siebte MRAM-Zellenanordnung erzeugt. Speicherzellen umfassen jeweils einen der Transistoren und einen der Speicherelemente, die in Reihe geschaltet sind. Die Speicherzellen sind jeweils zwischen der zugehörigen Bitleitung Bg und der zugehörigen Schreibleitung SLg geschaltet (siehe Figur 19b).

In einem achten Ausführungsbeispiel werden ausgehend von einem achten Substrat h wie im siebten Ausführungsbeispiel eine isolierende Struktur I1h, planare Transistoren Th, Gate-Leitungen GLh, Ätzstop-Strukturen Ah und eine erste isolierende Schicht 1h erzeugt.

Ähnlich wie im siebten Ausführungsbeispiel werden Kontaktlöcher für tiefe Kontakte KTh erzeugt, mit dem Unterschied, daß die Ätzstop-Strukturen Ah aus Siliziumnitrid ebenfalls geätzt werden. Als Ätzmittel ist z.B. CHF₃+O₂ geeignet. Dadurch kontaktieren die unteren Kontakte KTh zusätzlich die Gate-Leitungen GLh.

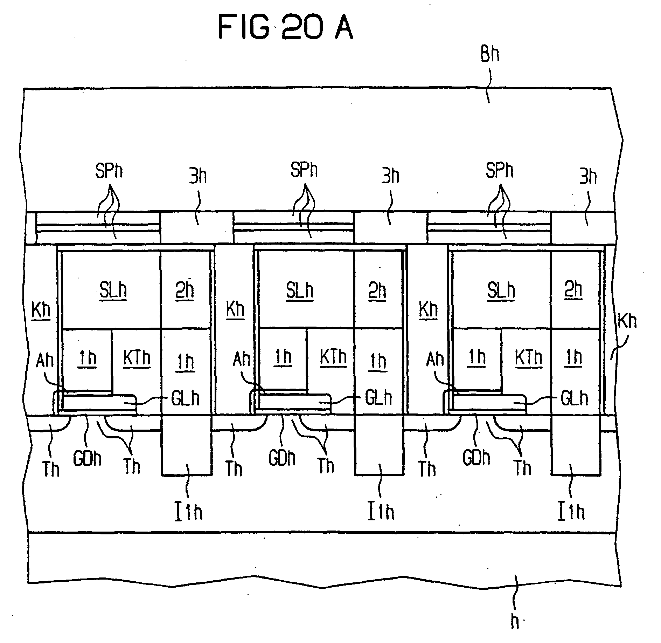

Wie im siebten Ausführungsbeispiel werden eine zweite isolierende Schicht 2h, Kontakte Kh, Schreibleitungen SLh, Speicherelemente SPh, eine dritte isolierende Schicht 3h und Bitleitungen Bh erzeugt (siehe Figur 20a).

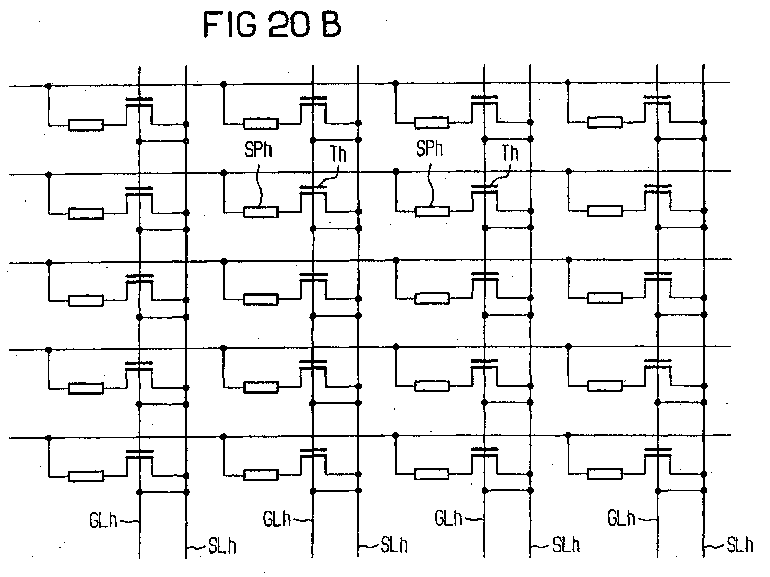

Durch das beschriebene Verfahren wird eine achte MRAM-Zellenanordnung erzeugt. Speicherzellen umfassen. jeweils einen der Transistoren Th und einen der Speicherelemente SPh, die in Reihe geschaltet sind. Die Speicherzellen sind jeweils zwischen der zugehörigen Bitleitung Bh und der zugehörigen Schreibleitung SLh geschaltet. Beim Programmieren einer der Speicherzellen, wird der zugehörige Transistor Th angesteuert, da die zugehörige Schreibleitung SLh mit der Gate-Leitung GLh des Transistors Th elektrisch verbunden ist (siehe Figur 20b).

Es sind viele Variationen der Ausführungsbeispiele denkbar, die ebenfalls im Rahmen der Erfindung liegen. Insbesondere können die Abmessungen der beschriebenen Schichten, Gräben, Masken, Spacer, Gebiete, Leitungen und-Strukturen nach Belieben an die jeweiligen Erfordernisse angepaßt werden. Dasselbe gilt auch für die vorgeschlagenen Dotierstoffkonzentrationen. Leitfähigkeitstypen der Schichten, Gebiete, Wannen und Substrate können vertauscht werden. Die Ausführungsbeispiele können beispielsweise skaliert werden. Dazu werden die Abmessungen entsprechend einem Skalierungsfaktor korrigiert.

Merkmale der acht Ausführungsbeispiele können miteinander kombiniert werden. Ein Unterschied zwischen dem vierten und dem fünften Ausführungsbeispiel besteht darin, daß im fünften Ausführungsbeispiel folded Bitleitungen vorgesehen sind, die mit Hilfe alternierend angeordneter Channel-Stop-Gebiete und durch Anordnung zweier Gate-Leitungen pro Graben realisiert werden. Diese Merkmale können ohne weiteres in das erste und das sechste Ausführungsbeispiel integriert werden, um Varianten mit folded Bitleitungen zu erhalten. Merkmale aus dem vierten und fünften Ausführungsbeispiel, die die seitliche Kontaktierung der Speicherelemente ermöglichen, können an Stelle der Kontaktierung von unten treten.

## Patentansprüche

1. Speicherzellenanordnung mit einer Mehrzahl von matrixförmig in Reihen und Spalten angeordneten Speicherzellen, wobei:
jede Speicherzelle ein Speicherelement umfaßt, dessen Widerstand eine Information darstellt und durch ein Magnetfeld beeinflußbar ist;
in Reihenrichtung eine Mehrzahl von Schreibleitungen (SLa-h) und in Spaltenrichtung eine Mehrzahl quer dazu verlaufender Bitleitungen (Ba-h) vorgesehen sind, die sich im Bereich eines jeweiligen dazwischenliegenden Speicherelements kreuzen und die beide der Erzeugung des Magnetfeldes dienen;
über eine jeweilige Schreibleitung (SLa-h) die Speicherelemente einer Spalte von der Oberseite magnetisch beeinflußbar sind;
**dadurch gekennzeichnet, daß**
jede Speicherzelle einen einzigen, unter dem Speicherelement gelegenen Transistor umfaßt, der in Reihe zum Speicherelement geschaltet ist und über den das Speicherelement mit einem ersten Referenzpotential verbindbar ist;
über eine jeweilige Bitleitung (Ba-h) die Speicherelemente einer Reihe mit einem zweiten Referenzpotential verbindbar und von der Unterseite magnetisch beeinflußbar sind; und
in Spaltenrichtung eine Mehrzahl von Ansteuerleitungen (G1a-h) für die Transistoren vorgesehen ist, die quer zu den Bitleitungen (Ba-h) verlaufen.

2. Speicherzellenanordnung nach Anspruch 1, bei der die Speicherzellen zwischen der Bitleitung (Ba) und einem für die Speicherzellen gemeinsamen ersten Referenzpotential geschaltet sind.

3. Speicherzellenanordnung nach Anspruch 2, bei der die Schreibleitung (SLf) und die Ansteuerleitung (GLf) zusammenfallen.

4. Speicherzellenanordnung nach einem der Ansprüche 1 bis 3,
- bei der ein jeweiliges erstes Source/Drain-Gebiet (1S/Da) der Transistoren über einen jeweiligen Kontakt (Ka) mit dem über dem jeweiligen Transistor angeordneten Speicherelement elektrisch verbunden ist, und
- bei der die Schreibleitungen (SLa-f) unter dem Speicherelement und neben dem Kontakt (Ka) angeordnet und durch eine Isolation (Ia) vom Speicherelement isoliert sind.

5. Speicherzellenanordnung nach einem der Ansprüche 1 bis 4,
- bei der die Transistoren als planare MOS-Transistoren ausgebildet sind, und
- bei der die Transistoren von entlang der Bitleitung (Bc) benachbarten Speicherzellen paarweise ein gemeinsames zweites Source/Drain-Gebiet (2S/Dc) aufweisen.

6. Speicherzellenanordnung nach Anspruch 4,
- bei der die Transistoren als vertikale MOS-Transistoren ausgebildet sind,
- bei der in einer Halbleiterstruktur (STa) das jeweilige erste Source/Drain-Gebiet (1S/Da) über einem zugehörigen jeweiligen Kanalgebiet (KAa) angeordnet ist,
- bei der die Ansteuerleitungen (GLa) an einer ersten Flanke der Halbleiterstruktur (STa) angeordnet sind,
- bei der ein jeweiliges Element (Ca), das die Ausbildung eines Kanals verhindert an eine zweite, der ersten Flanke gegenüberliegende Flanke der Halbleiterstruktur (STa) angrenzt,
- bei der eine Gate-Leitung (GLa), die einen Transistor einer entlang der Bitleitung (Ba) benachbarten Speicherzelle ansteuert, an der zweiten Flanke der Halbleiterstruktur (STa) angeordnet ist.

7. Speicherzellenanordnung nach Anspruch 6, bei der zweite Source/Drain-Gebiete (2S/Da) der Transistoren als eine durchgängige Schicht ausgebildet sind, die mit dem ersten Referenzpotential verbunden sind.

8. Speicherzellenanordnung nach einem der Ansprüche 1 bis 7,
- bei der die Speicherelemente mindestens zwei magnetische Schichten (F1a, F2a), die unterschiedliche Schwellenfelder zur Änderung ihrer Magnetisierungsrichtung benötigen, und eine dazwischen angeordnete nicht magnetische Schicht (Ea) umfassen, und
- bei der die Speicherelemente so kontaktiert sind, daß der Stromfluß senkrecht zu den Ebenen seiner Schichten (F1a, F2a, Ea) erfolgt.

9. Verfahren zur Herstellung einer Speicherzellenanordnung nach Anspruch 1,
- bei dem im wesentlichen parallel zueinander verlaufende Gräben (Ga) erzeugt werden, wodurch streifenförmige Halbleiterstrukturen (STa) entstehen,
- bei dem als Teile der Halbleiterstrukturen (STa) erste Source/Drain-Gebiete (1S/Da) und darunter angeordnete Kanalgebiete (KAa) von vertikalen Transistoren erzeugt werden,
- bei dem zumindest an Teilen von ersten Flanken der Halbleiterstrukturen (STa) durch schräge Implantation Channel-Stop-Gebiete (Ca) erzeugt werden,
- bei dem in den Gräben (Ga) über einem Dielektrikum (GDa) die Ansteuerleitungen (GLa) zum Ansteuern der Transistoren an zweiten Flanken der Halbleiterstrukturen (GLa) erzeugt werden,
- bei dem die Speicherelemente mit jeweils einem ersten Source/Drain-Gebiet (1S/Da) der Transistoren verbunden werden.

10. Verfahren nach Anspruch 9,
- bei dem die Channel-Stop-Gebiete (Ce) durch zwei maskierte schräge Implantationen so erzeugt werden, daß sie entlang der Halbleiterstruktur (STe) alternierend an einer ersten Flanke und an einer zweiten Flanke der Halbleiterstruktur (STe) angeordnet sind,
- bei dem in jedem der Gräben (Ge) zwei Gate-Leitungen (GLe) erzeugt werden, indem leitendes Material abgeschieden und rückgeätzt wird, bis die Gate-Leitungen (GLe) in Form von Spacern erzeugt werden.

11. Verfahren nach einem der Ansprüche 9 bis 10,
- bei dem auf dem ersten Source/Drain-Gebiet (1S/Da) des Transistors ein Kontakt (Ka) erzeugt wird,
- bei dem neben dem Kontakt (Ka) die Schreibleitung (SLa) aus weicherem Material als das Material des Kontakts (Ka) erzeugt wird, wobei eine obere Fläche der Schreibleitung (SLa) auf gleicher Höhe oder höher als die Höhe einer oberen Fläche des Kontakts (Ka) liegt,
- bei dem durch chemisch mechanisches Polieren die Schreibleitung (SLa) abgetragen wird, bis der Kontakt (Ka) etwas hervorsteht,
- bei dem auf der Schreibleitung (SLa) eine Isolation (Ia) erzeugt wird, indem isolierendes Material abgeschieden und planarisiert wird, bis die obere Fläche des Kontakts (Ka) freigelegt wird,
- bei dem oberhalb der Isolation (Ia) und oberhalb und angrenzend an den Kontakt (Ka) das Speicherelement als Teil der Speicherzelle erzeugt wird,
- bei dem über dem Speicherelement die quer zur Schreibleitung (SLa) verlaufende Bitleitung (Ba) erzeugt undmit dem Speicherelement elektrisch verbunden wird.

12. Verfahren nach einem der Ansprüche 9 bis 11,
- bei dem nach Erzeugung des Transistors eine isolierende Schicht (1a) erzeugt wird, in der der Kontakt (Ka) erzeugt wird,
- bei dem mit Hilfe einer streifenförmigen Maske (M2a), die den Kontakt (Ka) teilweise überlappt, die isolierende Schicht (1a) geätzt wird, und anschließend leitendes Material abgeschieden und rückgeätzt oder planarisiert wird, wodurch die Schreibleitung (SLa) erzeugt wird.

13. Verfahren nach Anspruch 12,
bei dem die isolierende Schicht (1f) durchtrennt wird, bis die Gate-Leitung (GLf) freigelegt wird.

## Claims

1. Memory cell arrangement having a plurality of memory cells arranged in matrix form in rows and columns, in which case:
each memory cell comprises a memory element whose resistance represents an information item and can be influenced by a magnetic field;
a plurality of write lines (S1a-h) are provided in the row direction and a plurality of bit lines (Ba-h) running transversely with respect thereto are provided in the column direction, which cross in the region of a respective memory element lying in between and which both serve for generating the magnetic field;
the memory elements of a column can be magnetically influenced from the top side via a respective right line (S1a-h);
**characterized in that**
each memory cell comprises a single transistor, which is located below the memory element and is connected in series with the memory element and via which the memory element can be connected to a first reference potential;
the memory elements of a row can be connected to a second reference potential and can be magnetically influenced from the underside via a respective bit line (Ba-h);
and
a plurality of drive lines (Gla-h) are provided for the transistors in the column direction, which run transversely with respect to the bit lines (Ba-h).

2. Memory cell arrangement according to Claim 1,
in which the memory cells are connected between the bit line (Ba) and a first reference potential which is common to the memory cells.

3. Memory cell arrangement according to Claim 2,
in which the write line (SLf) and the drive line (GLf) coincide.

4. Memory cell arrangement according to one of Claims 1 to 3,
- in which a respective first source/drain region (1S/Da) of the transistors is electrically connected via a respective contact (Ka) to the memory element arranged above the respective transistor, and
- in which the write lines (S1a-f) are arranged under the memory element and next to the contact (Ka) and are insulated from the memory element by an insulation (Ia).

5. Memory cell arrangement according to one of Claims 1 to 4,
- in which the transistors are designed as planar MOS transistors, and
- in which the transistors of adjacent memory cells along the bit line (Bc) have, in pairs, a common second source/drain region (2S/Dc).

6. Memory cell arrangement according to claim 4,
- in which the transistors are designed as vertical MOS transistors,
- in which, in a semiconductor structure (STa), the respective first source/drain region (1S/Da) is arranged above an associated respective channel region (KAa),
- in which the drive lines (GLa) are arranged on a first sidewall of the semiconductor structure (STa),
- in which a respective element (Ca) which prevents the formation of a channel joins a second sidewall, opposite the first side wall, of the semiconductor structure (STa),
- in which a gate line (GLa) which drives a transistor of an adjacent memory cell along the bit line (Ba) is arranged on the second sidewall of the semiconductor structure (STa).

7. Memory cell arrangement according to Claim 6,
in which second source/drain regions (2S/Da) of the transistors are designed as a continuous layer and are connected to the first reference potential.

8. Memory cell arrangement according to one of Claims 1 to 7,
- in which the memory elements comprise at least two magnetic layers (F1a, F2a), which require different threshold fields for changing their magnetization direction, and a non-magnetic layer (Ea) arranged in between,
- in which the memory elements are contact-connected in such a way that current flows perpendicularly to the planes of its layers (F1a, F2a, Ea).

9. Method for fabricating a memory cell arrangement according to Claim 1,
- in which trenches (Ga) running essentially parallel to one another are produced, as a result of which strip-type semiconductor structures (STa) are produced,
- in which first source/drain regions (1S/Da) and, arranged under the latter, channel regions (KAa) of vertical transistors are produced as parts of the semiconductor structures (STa),
- in which channel stop regions (Ca) are produced at least on parts of first sidewalls of the semiconductor structures (STa) by means of inclined implantation,
- in which the drive lines (GLa) for driving the transistors are produced, on second sidewalls of the semiconductor structures (G1a), in the trenches (Ga) above a dielectric (Gda),
- in which the memory elements are each connected to a first source/drain region (1S/Da) of the transistors.

10. Method according to Claim 9,
- in which the channel stop regions (Ce) are produced by means of two masked inclined implantations in such a way that they are arranged along the semiconductor structure (STe) alternately on a first sidewall and on a second sidewall of the semiconductor structure (STe),
- in which two gate lines (GLe) are produced in each of the trenches (Ge) by conductive material being deposited and etched back until the gate lines (GLe) are produced in the form of spacers.

11. Method according to one of Claims 9 to 10,
- in which a contact (Ka) is produced on the first source/drain region (1S/Da) of the transistor,
- in which, next to the contact (Ka), the write line (SLa) is produced from softer material than the material of the contact (Ka), an upper area of the write line (SLa) lying at the same level or higher than the level of an upper area of the contact (Ka),
- in which the write line (SLa) is removed by chemical mechanical polishing until the contact (Ka) protrudes somewhat,
- in which an insulation (Ia) is produced on the write line (SLa) by insulating material being deposited and planarized until the upper area of the contact (Ka) is uncovered,
- in which, above the insulation (Ia) and above and adjoining the contact (Ka), the memory element is produced as part of the memory cell,
- in which the bit line (Ba) running transverse with respect to the write line (SLa) is produced above the memory element and electrically connected to the memory element.

12. Method according to one of Claims 9 to 11,
- in which after the production of the transistor, an insulating layer (1a) is produced, in which the contact (Ka) is produced,
- in which, with the aid of a strip-type mask (M2a) which partially overlaps the contact (Ka), the insulating layer (1a) is etched, and then conductive material is deposited and etched back or planarized, as a result of which the write line (SLa) is produced.

13. Method according to Claim 12,
in which the insulating layer (1f) is cut through until the gate line (GLf) is uncovered.

## Revendications

1. Agencement de cellules de mémoire comprenant une pluralité de cellules de mémoire agencées en forme de matrice par lignes et colonnes, dans lequel
chaque cellule de mémoire comprend un élément de mémoire, dont la résistance représente une information et qui est influençable par un champ magnétique ;
il est prévu dans le sens des lignes une pluralité de lignes d' écriture (SLa-h) et dans le sens des colonnes une pluralité de lignes de bits (Ba-h), qui se croisent dans la zone d'un élément de mémoire situé respectivement entre lesdites lignes et qui servent toutes deux à générer le champ magnétique ;
les éléments de mémoire d'une colonne pouvant être influencés par voie magnétique par la face supérieure par l'intermédiaire d'une ligne d'écriture (SLa-h) correspondante ;
**caractérisé en ce que**
chaque cellule de mémoire comporte un seul transistor situé au-dessous de l'élément de mémoire, lequel transistor est monté en série avec l'élément de mémoire et par lequel l'élément de mémoire peut être relié à un premier potentiel de référence ;
les éléments de mémoire d'une ligne pouvant, par l'intermédiaire d'une ligne de bits (Ba-h) correspondante, être reliés à un deuxième potentiel de référence et influencés par voie magnétique par la face inférieure ; et
une pluralité de lignes de grille (GLa-h) étant prévues dans le sens des colonnes pour les transistors, lesquelles s'étendent transversalement aux lignes de bits (Ba-h).

2. Agencement de cellules de mémoire selon la revendication 1,
dans lequel les cellules de mémoire sont montées entre la Ligne de bits (Ba) et un premier potentiel de référence commun aux cellules de mémoire.

3. Agencement de cellules de mémoire selon la revendication 2,
dans lequel la ligne d'écriture (SLf) et la ligne de grille (GLf) coïncident.

4. Agencement de cellules de mémoire selon une des revendications 1 à 3,
- dans lequel chacune des premières zones source-drain (1S/Da) des transistors est reliée électriquement par i'intermédiaire d'un contact (Ka) correspondant à l'élément de mémoire agencé au-dessus du transistor correspondant, et
- dans lequel les lignes d'écriture (SLa-f) sont agencées au-dessous de l'élément de mémoire et à côté du contact (Ka) et sont séparées de l'élément de mémoire par une isolation (Ia).

5. Agencement de cellules de mémoire selon une des revendications 1 à 4,
- dans lequel les transistors sont conçus sous forme de transistors MOS planaires, et
- dans lequel les transistors des cellules de mémoire voisines le long de la ligne de bits (Bc) comportent deux par deux une deuxième zone source-drain (2S/Dc) commune.

6. Agencement de cellules de mémoire selon la revendication 4,
- dans lequel les transistors sont conçus sous forme de transistors MOS verticaux,
- dans lequel chaque première zone source-drain (1S/Da), dans une structure de semi-conducteur (STa), est agencée au-dessus d'une zone de canaux (KAa) correspondante,
- dans lequel les lignes de grille (GLa) sont agencées sur un premier flanc de la structure de semi-conducteur (STa),
- dans lequel chaque élément (Ca), qui empêche la formation d'un canal, est adjacent à un deuxième flanc, face au premier flanc, de la structure de semi-conducteur (STa),
- dans lequel une ligne de grille (GLa), qui commande un transistor d'une cellule de mémoire voisine le long de la ligne de bits (Ba), est agencée sur le deuxième flanc de la structure de semi-conducteur (STa).

7. Agencement de cellules de mémoire selon la revendication 6,
dans lequel des deuxièmes zones source-drain (2S/Da) des transistors sont conçues sous forme de couche continue, qui est reliée au premier potentiel de référence.

8. Agencement de cellules de mémoire selon une des revendications 1 à 7,
- dans lequel les éléments de mémoire comportent au moins deux couches magnétiques (F1a, F2a), qui nécessitent différents champs seuils pour faire varier leur direction d'aimantation, et une couche non magnétique (Ea) agencée entre les deux, et
- dans lequel les éléments de mémoire sont mis en contact de telle sorte que le flux de courant est perpendiculaire aux plans des couches (F1a, F2a, Ea) de ceux-ci.

9. Procédé de fabrication d'un agencement de cellules de mémoire selon la revendication 1,
- dans lequel des tranchées (Ga), sensiblement parallèles les unes aux autres, sont réalisées de manière à obtenir des structures de semi-conducteurs (STa) en forme de bandes,
- dans lequel sont réalisées par des transistors verticaux des premières zones source-drain (1S/Da), en tant que parties des structures de semi-conducteurs (STa), et des zones de canaux (KAa) disposées au-dessous de celles-ci,
- dans lequel des zones de suppression de canaux (Ca) sont formées par implantation oblique au moins sur des parties des premiers flancs des structures de semi-conducteurs (STa),
- dans lequel les lignes de grille (GLa), destinées à activer les transistors, sont réalisées dans les tranchées (Ga) au-dessus d'un diélectrique (GDa) au niveau des deuxièmes flancs des structures de semi-conducteurs (STa),
- dans lequel les éléments de mémoire sont reliés chacun à une première zone source-drain (1S/Da) des transistors.

10. Procédé selon la revendication 9,
- dans lequel les zones de suppression de canaux (Ce) sont réalisées par deux implantations obliques masquées, de telle sorte qu'elles sont disposées en alternance sur un des premiers flancs et sur un des deuxièmes flancs des structures de semi-conducteurs (STe),
- dans lequel deux lignes de grille (GLe) sont réalisées dans chacune des tranchées (Ge), par le fait qu'un matériau conducteur est déposé et gravé en retrait jusqu'à ce que les lignes de grille (GLe) soient réalisées sous forme d'éléments d'écartement.

11. Procédé selon une des revendications 9 à 10,
- dans lequel un contact (Ka) est réalisé sur la première zone source-drain (1S/Da) du transistor,
- dans lequel la ligne d'écriture (SLa) est réalisée dans un matériau moins dur que le matériau du contact (Ka) à côté du contact (Ka), une face supérieure de la ligne d'écriture (SLa) étant située à même hauteur ou plus haut qu'une face supérieure du contact (Ka),
- dans lequel la ligne d'écriture (SLa) est érodée par polissage chimico-mécanique, jusqu'à ce que le contact (KA) s'avance légèrement en saillie,
- dans lequel une isolation (Ia) est réalisée au-dessus de la ligne d'écriture (SLa), par le fait qu'un matériau isolant est déposé et aplani jusqu'à ce que la face supérieure du contact (Ka) soit dégagée,
- dans lequel l'élément de mémoire est réalisé sous forme d'une partie de la cellule de mémoire au-dessus de l'isolation (Ia) et au-dessus du contact (Ka) et adjacent à celui-ci,
- dans lequel la ligne de bits (Ba), transversale à la ligne d'écriture (SLa), est formée au-dessus de l'élément de mémoire et est reliée électriquement à l'élément de mémoire.

12. Procédé selon une des revendications 9 à 11,
- dans lequel une couche isolante (la), dans laquelle est formé le contact (Ka), est réalisée après la réalisation du transistor,
- dans lequel est gravée la couche isolante (la) à l'aide d'un masque (M2a) en forme de bandes, qui recouvre partiellement le contact (Ka), et ensuite un matériau conducteur est déposé et grevé ou aplani de manière à obtenir la ligne de mots (SLa).

13. Procédé selon la revendication 12,
dans lequel la couche isolante (1f) est sectionnée jusqu'à ce que la ligne de grille (GLf) soit dégagée.
